# EUROPEAN PATENT APPLICATION

(11) **EP 1 873 833 A1**
(43) Date of publication of application: **02.01.2008**
(21) Application number: 07011733.8
(22) Date of filing: 15.06.2007
(51) Int. Cl.: H01L 27/12, H01L 21/84

(54) **Thin film transistor array substrate and method of fabricating the same**

(30) Priority: 30.06.2006 KR 20060060246
(71) Applicant: Samsung Electronics Co., Ltd., Yeongtong-gu Suwon-city, Gyeonggi-do 442-742 (KR)
(72) Inventor: Chin, Hong-kee, Suwon-si Gyeonggi-do (KR); Kim, Sang-gab, Seoul (KR); Oh, Min-seok, Yongin-si Gyeonggi-do (KR); Kim, Joo-han, Yongin-si Gyeonggi-do (KR)
(74) Representative: Schmidt, Sven Hendrik

(57) **Abstract**

A thin film transistor (TFT) array substrate is provided in which a sufficiently large contact area between conductive materials is provided in a contact portion, and a method of fabricating the TFT array substrate. The TFT array substrate includes a gate interconnection line arranged on an insulating substrate, a gate insulating layer covering the gate interconnection line, a semiconductor layer arranged on the gate insulating layer, a data interconnection line including a data line, a source electrode, and a drain electrode arranged on the semiconductor layer, a first passivation film arranged on the data interconnection line and exposing the drain electrode, a second passivation film arranged on the first passivation film, and a pixel electrode electrically connected with the drain electrode. An outer sidewall of the second passivation film is positioned inside an outer sidewall of the first passivation film.

## Description

### BACKGROUND OF THE INVENTION

### FIELD OF THE INVENTION

The present invention relates to a thin film transistor ("TFT") array substrate and a method of fabricating the same, and more particularly, to a TFT array substrate in which a driving margin may be increased and a sufficiently large contact area between conductive materials may be provided in a contact portion, and a method of fabricating the TFT array substrate.

### DISCUSSION OF THE BACKGROUND

A liquid crystal display ("LCD") includes two opposing display panels and a liquid crystal layer interposed therebetween. Each display panel may use a transparent insulating substrate as a supporting substrate. A plurality of thin film patterns may be formed on the insulating substrate. A thin film pattern formation includes a material deposition and a mask process. However, a photolithography process may include multiple steps, such as photoresist coating, mask arrangement, exposure, baking, development, and cleaning, thus increasing the entire processing time and the manufacturing cost.

In order to reduce the number of mask processes, a lift-off method has been studied. More specifically, when a passivation film and a pixel electrode are formed on a TFT array substrate, the passivation film is patterned using a photoresist pattern, a conductive material is deposited on the entire surface of the TFT array substrate, and the photoresist pattern and the conductive material thereon are simultaneously removed using a photoresist stripper. The conductive material remaining on the substrate forms a pixel electrode.

The photoresist stripper may contact the sides or bottom of the photoresist pattern to remove the photoresist pattern covered with the conductive material. To prevent a pattern defect due to a residual portion of the photoresist pattern remaining on the substrate, the contact area of the photoresist pattern with the photoresist stripper should be sufficiently large. Specifically, the passivation film under the photoresist pattern should form a sufficiently large undercut under the inner side of the photoresist pattern. However, if the passivation film is over-etched to form such an undercut, an insulating film on a storage electrode may be over-etched and its thickness may become non-uniform, thus causing a reduction in a driving margin. Moreover, a data interconnection line may be damaged by over-etching, and etching of the data interconnection line in a contact area may cause a contact failure.

### SUMMARY OF THE INVENTION

This invention provides a TFT array substrate that increases a driving margin and provides a sufficiently large contact area between conductive materials in a contact portion.

The present invention also provides a TFT array substrate that enables easy lift-off and prevents over-etching of a gate insulating layer and damage to a data interconnection line.

Additional features of the invention will be set forth in the description which follows, and in part will be apparent from the description, or may be learned by practice of the invention.

The present invention discloses a thin film transistor (TFT) array substrate including a gate interconnection line including a gate line and a gate electrode arranged on an insulating substrate, a gate insulating layer covering the gate interconnection line, a semiconductor layer arranged on the gate insulating layer, a data interconnection line including a data line, a source electrode, and a drain electrode arranged on the semiconductor layer, a first passivation film arranged on the data interconnection line and exposing a portion of the drain electrode, a second passivation film arranged on the first passivation film, wherein an outer sidewall of the second passivation film is positioned inside an outer sidewall of the first passivation film, and a pixel electrode connected to the drain electrode.

The present invention also discloses a method of fabricating a thin film transistor (TFT) array substrate, the method including forming a gate interconnection line on an insulating substrate, the gate interconnection line including a gate line and a gate electrode, forming a gate insulating layer on the gate interconnection line, forming a semiconductor layer and a data interconnection line on the semiconductor layer, the data interconnection line including a data line, a source electrode, and a drain electrode, sequentially forming a first passivation film and a second passivation film on the data interconnection line, etching the second passivation film and the first passivation film, and exposing a drain electrode of a drain electrode-pixel electrode contact portion, and forming a pixel electrode connected to the drain electrode. Further, etching the second passivation film and the first passivation film includes forming an outer sidewall of the second passivation film inside an outer sidewall of the first passivation film.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a layout of a TFT array substrate according to a first exemplary embodiment of the present invention.

FIG. 2A is a cross-sectional view taken along line A-A' of FIG. 1.

FIG. 2B is a cross-sectional view taken along line B-B' of FIG. 1.

FIG. 2C is a cross-sectional view taken along line C-C' of FIG. 1.

FIGS. 3A, 4A, 5A, 6A, 7A, 8A, 9A, 10A, and 11A are cross-sectional views showing processing steps of the method of fabricating the TFT array substrate cross-sectional view shown in FIG. 2A according to a second exemplary embodiment of the present invention.

FIGS. 3B, 4B, 5B, 6B, 7B, 8B, 9B, 10B, and 11B are cross-sectional views showing processing steps of the method of fabricating the TFT array substrate cross-sectional view shown in FIG. 2B according to the second exemplary embodiment of the present invention.

FIGS. 3C, 4C, 5C, 6C, 7C, 8C, 9C, 10C, and 11C are cross-sectional views showing processing steps of the method of fabricating the TFT array substrate cross-sectional view shown in FIG. 2C according to the second exemplary embodiment of the present invention.

FIGS. 12A, 13A, 14A, and 15A are cross-sectional views showing processing steps of the method of fabricating the TFT array substrate cross-sectional view shown in FIG. 2A according to the third exemplary embodiment of the present invention.

FIGS. 12B, 13B, 14B, and 15B are cross-sectional views showing processing steps of the method of fabricating the TFT array substrate cross-sectional view shown in FIG. 2B according to the third exemplary embodiment of the present invention.

FIGS. 12C, 13C, 14C, and 15C are cross-sectional views showing processing steps of the method of fabricating the TFT array substrate cross-sectional view shown in FIG. 2C according to the third exemplary embodiment of the present invention.

FIG. 16 is a layout of a TFT array substrate according to a fourth exemplary embodiment of the present invention.

FIG. 17A is a cross-sectional view taken along line A-A' of FIG. 16.

FIG. 17B is a cross-sectional view taken along line B-B' of FIG. 16.

FIG. 17C is a cross-sectional view taken along line C-C' of FIG. 16.

**FIGS.** 18A, 19A, 20A, and 21A are cross-sectional views showing processing steps of the method of fabricating the TFT array substrate cross-sectional view shown in FIG. 17A according to a fifth exemplary embodiment of the present invention.

FIGS. 18B, 19B, 20B, and 21B are cross-sectional views showing processing steps of the method of fabricating the TFT array substrate cross-sectional view shown in FIG. 17B according to the fifth exemplary embodiment of the present invention.

FIGS. 18C, 19C, 20C, and 21C are cross-sectional views showing processing steps of the method of fabricating the TFT array substrate cross-sectional view shown in FIG. 17C according to the fifth exemplary embodiment of the present invention.

FIGS. 22A and 23A are cross-sectional views showing processing steps of the method of fabricating the TFT array substrate cross-sectional view shown in FIG. 17A according to a sixth exemplary embodiment of the present invention.

FIGS. 22B and 23B are cross-sectional views showing processing steps of the method of fabricating the TFT array substrate cross-sectional view shown in FIG. 17B according to the sixth exemplary embodiment of the present invention.

FIGS. 22C and 23C are cross-sectional views showing processing steps of the method of fabricating the TFT array substrate cross-sectional view shown in FIG. 17C according to the sixth exemplary embodiment of the present invention.

### DETAILED DESCRIPTION OF THE ILLUSTRATED EMBODIMENTS

Advantages and features of the present invention and methods of accomplishing the same may be understood more readily by reference to the following detailed description of preferred embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims. In the drawings, the thickness of layers and regions are exaggerated or reduced for clarity.

In the following description, it will be understood that when an element or a layer is referred to as being "on" or "connected to" another element or layer, it can be directly on or directly connected to the other element or layer, or intervening layers or elements may also be present. In contrast, when an element is referred to as being "directly on" or "directly connected to" another element, there are no intervening elements present. Like reference numerals refer to like elements throughout the specification. The terms "and/or" comprises each and at least one combination of referenced items.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

The present invention will be described with reference to perspective views, cross-sectional views, and/or plan views, in which preferred embodiments of the invention are shown. Thus, the profile of an exemplary view may be modified according to manufacturing techniques and/or allowances. That is, the embodiments of the invention are not intended to limit the scope of the present invention but cover all changes and modifications that can be caused due to a change in manufacturing process. Thus, regions shown in the drawings are illustrated in schematic form and the shapes of the regions are presented simply by way of illustration and not as a limitation.

Hereinafter, a TFT array substrate according to the exemplary embodiments of the present invention will be described in detail with reference to the accompanying drawings.

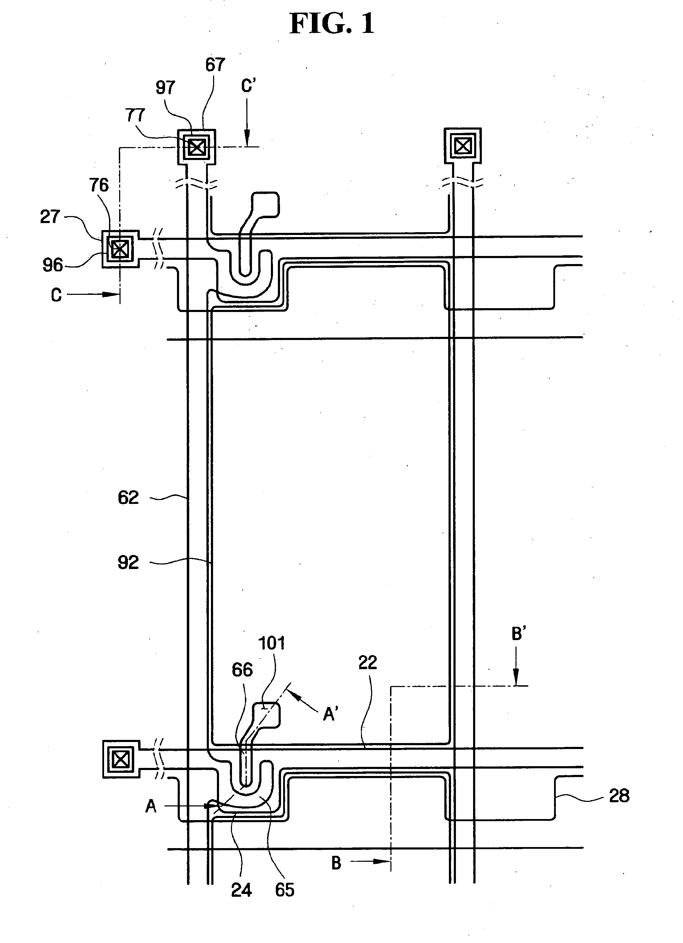

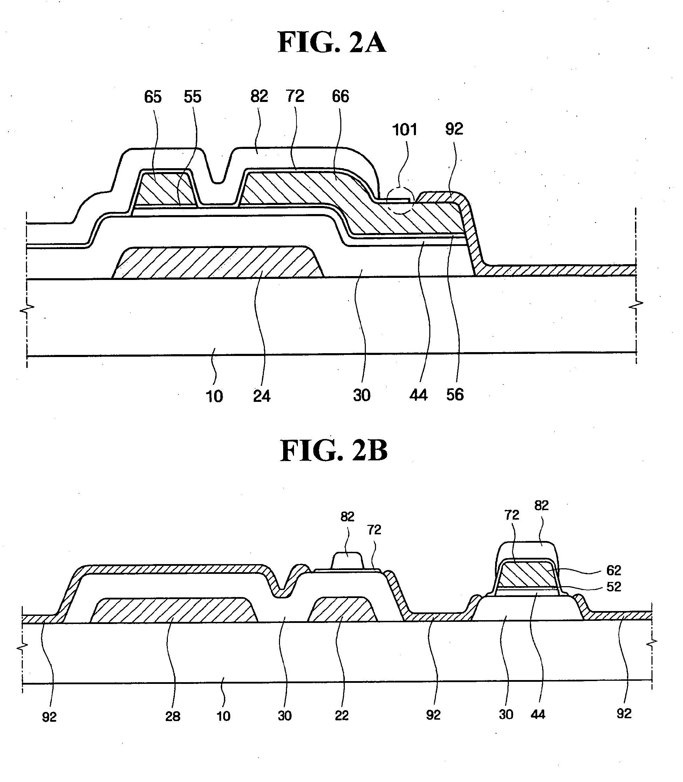

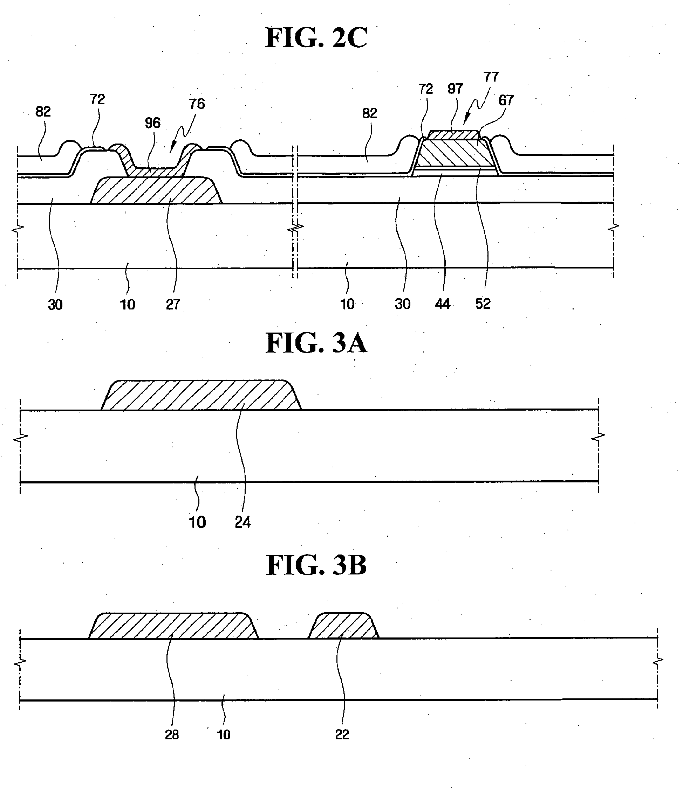

FIG. 1 is a layout of a TFT array substrate according to a first embodiment of the present invention, and FIG. 2A, FIG. 2B, and FIG. 2C are cross-sectional views taken along lines A-A', B-B', and C-C', respectively, of FIG. 1.

A TFT array substrate according to a first exemplary embodiment of the present invention includes a TFT arranged on an insulating substrate, a first passivation film covering the TFT, and a second passivation film arranged on the first passivation film. The TFT is a three-terminal device including a control terminal, an input terminal, and an output terminal and may include a gate electrode, a source electrode, a drain electrode, and a semiconductor layer. In the TFT, unless otherwise described, the gate electrode may be the control terminal, the source electrode may be the input terminal, and the drain electrode may be the output terminal. The semiconductor layer may form a channel region of the TFT.

Referring to FIG. 1, FIG. 2A, FIG. 2B, and FIG. 2C, an insulating substrate 10 supports a TFT and may be formed of, for example, transparent glass or plastic. A gate line 22, a gate pad 27, and a gate electrode 24 are arranged on the insulating substrate 10.

Plural gate lines 22 for gate signal transmission are disposed on the insulating substrate 10. The gate lines 22 are spaced apart from each other and extend parallel with each other in a first direction, such as a transverse direction shown in FIG. 1. A gate pad 27 having an expanded width is connected to an end of each gate line 22. In modified embodiments of the invention, although not shown, the gate pad 27 may be arranged at two opposite terminals of the gate line 22, or may not be formed.

The gate electrode 24 is connected to the gate line 22. Plural gate electrodes 24 may also be connected to the gate line 22. Each gate electrode 24 may extend out from the gate line 22.

The gate electrode 24, the gate line 22, and the gate pad 27 may be arranged directly on the insulating substrate 10. Throughout this specification, the gate electrode 24, the gate line 22, and the gate pad 27 may be collectively referred to as a gate interconnection line for the convenience of explanation.

The storage electrode 28, which may be formed of the same material as the gate interconnection line, may be arranged directly on the insulating substrate 10. The storage electrode 28 is arranged in the vicinity of the gate line 22 and extends in the first direction parallel to the gate line 22. A storage electrode pad (not shown), which may be similar to the gate pad 27, may be arranged on at least a terminal of the storage electrode 28. The shape of the storage electrode 28 may vary but the invention is not limited to the shape shown in Fig. 1.

The gate interconnection line and the storage electrode 28 may be formed as a single layer and may be formed of aluminum (Al), copper (Cu), silver (Ag), molybdenum (Mo), chrome (Cr), titanium (Ti), tantalum (Ta), or alloys thereof, or as a multi-layered structure including combinations of these materials, but the invention is not limited thereto.

The gate insulation layer 30 may be formed of silicon nitride (SiNx) and may be arranged on the gate interconnection line and the storage electrode 28. However, the gate insulation layer 30 may not be arranged on the gate interconnection line in a gate contact portion 76 where the gate pad 27 contacts an auxiliary gate pad 96. The gate insulation layer 30 overlaps with the gate interconnection line and the insulating substrate 10 in an area where a data interconnection line, to be described below, is arranged. The gate insulation layer 30 may expose the insulating substrate 10 in a pixel area where a pixel electrode 92 is arranged.

A semiconductor layer 44 and ohmic contact layers 52, 55 and 56, which may be formed of silicide or n+ hydrogenated amorphous silicon doped with n-type impurities at high concentration, are arranged on the gate insulating layer 30. The semiconductor layer 44 is arranged in substantially the same pattern as the data interconnection line, to be described in further detail below, except for the channel region. A channel region of a thin film transistor corresponds to where the semiconductor layer 44 overlaps with the gate electrode 24. The ohmic contact layers 52, 55 and 56 are arranged in substantially the same pattern as the overlying data interconnection line, to be described in further detail below. The ohmic contact layers 52, 55 and 56 do not contact each other in a region corresponding to the channel region.

The data line 62, the data pad 67, the source electrode 65, and the drain electrode 66 are arranged on the semiconductor layer 44 and on the ohmic contact layers 52, 55 and 56.

Plural data lines 62 are disposed on the ohmic contact layers 52. The data lines 62 are spaced apart from each other and extend parallel with each other in a second direction, such as a longitudinal direction shown in FIG. 1. The data lines 62 cross with the gate lines 22. A data pad 67 having an expanded width is connected to an end of each data line 62. In modified embodiments of the invention, although not shown, the data pad 67 may be arranged at two opposite terminals of the data line 62, or may not be formed.

The source electrode 65 is connected to the data line 62. Plural source electrodes 65 may also be connected to each data line 62. Each source electrode 62 is opposite to and faces a drain electrode 66. The semiconductor layer 44 may be exposed between the source electrode 65 and the drain electrode 66. Throughout this specification, the data line 62, the data pad 67, the source electrode 62, and the drain electrode 66 may be collectively referred to as a data interconnection line for the convenience of explanation.

The data interconnection line may be formed as a single layer of Al, Cu, Ag, Mo, Cr, Ti, Ta, or alloys thereof, or as a multi-layered structure including combinations of these materials, but the invention is not limited thereto.

A first passivation film 72 is arranged on the data interconnection line except in an area where the drain electrode 66 contacts the pixel electrode 92, referred to as a drain electrode-pixel electrode contact portion 101, and except in an area where the data pad 67 contacts an auxiliary data pad 97, referred to as a data contact portion 77. The first passivation film 72 is also arranged on the channel region of the exposed semiconductor layer 44. In addition, the first passivation film 72 is arranged on the gate interconnection line except for the gate contact portion 76. Specifically, in an area where the gate interconnection line does not overlap with the data interconnection line, the first passivation film 72 is arranged on the gate insulating layer 30 in a region corresponding to the gate interconnection line. In an area where the gate interconnection line overlaps with the data interconnection line, the first passivation film 72 is arranged on the corresponding data interconnection line. An area where the gate interconnection line overlaps with the data interconnection line may include an area where the gate line 22 and the data line 62 intersect with each other, and in an area where the source electrode 65 and the drain electrode 66 overlap with the gate electrode 24. In the space between the source electrode 65 and the drain electrode 66, which overlaps with the gate electrode 24, the first passivation film 72 is arranged on the semiconductor layer 44. Referring to FIG. 2B, the first passivation film 72 is not positioned on the storage electrode 28. However, the invention is not limited thereto and the first passivation film 72 may be positioned on the storage electrode 28 in another exemplary embodiment of the invention.

The first passivation film 72 may be formed of silicon oxide (SiO₂) or silicon oxynitride (SiOₓN_{y}). The first passivation film 72 may have a thickness in a range of about 50 Å to about 500 Å, or in a range of about 100 Å to about 300 Å.

A second passivation film 82 is arranged on the first passivation film 72. The second passivation film 82 may overlap with the first passivation film 72. More specifically, the second passivation film 82 is arranged on the first passivation film 72 throughout the entire area of the TFT array substrate but does not entirely cover the first passivation film 72. In other words, the outer sidewall of the second passivation film 82 is positioned inside the outer sidewall of the first passivation film 72. The sidewall of the first passivation film 72 extends beyond the sidewall of the second passivation film 82. In another exemplary embodiment of the invention, where the first passivation film 72 is positioned on the storage electrode 28, the second passivation film 82 may or may not be positioned on the storage electrode 28.

In the area where the gate line 22 and the data line 62 are formed, the gate insulating layer 30 is patterned to expose the insulating layer 10 of the pixel area. Here, the gate insulating layer 30 extend beyond the second passivation film 82, and the outer sidewalls of the first passivation film 72 may be exposed by the second passivation film 82. Alternatively, the outer sidewall of the first passivation film 72 may be aligned with the outer sidewalls of the gate insulating layer 30. In another exemplary embodiment of the invention, although not shown, the outer sidewalls of the first passivation film 72 may extend beyond to be positioned outside the outer sidewalls of the the gate insulating layer 30.

The second passivation film 82 may be formed of silicon nitride (SiN). The second passivation film 82 may be thicker than the first passivation film 72. The second passivation film 82 may have a thickness in a range of about 1,000 Å to about 3,000 Å, or in a range of about 1,500 Å to about 2,500 Å.

The first passivation film 72 and the second passivation film 82 may protect lower structures such as the data interconnection line, the semiconductor layer 44, and the gate interconnection line.

In a formation area of the gate pad 27, the gate contact portion 76 is formed through the gate insulating layer 30, the first passivation film 72 and the second passivation film 82. In a formation area of the data pad 67, the data contact portion 77 is formed through the first passivation film 72 and the second passivation film 82.

The pixel electrode 92 may be made of a transparent conductive material such as indium tin oxide (ITO) or indium zinc oxide (IZO), or a material having superior reflectivity such as copper (Cu) or silver (Ag) may be arranged on the exposed insulating substrate 10 in the pixel area. The pixel electrode 92 extends to the drain electrode-pixel electrode contact portion 101 and is connected to the drain electrode 66 at the drain electrode-pixel electrode contact portion 101. The first passivation film 72 and the second passivation film 82 do not overlap with the pixel electrode 92. In a formation area of the storage electrode 28, the pixel electrode 92 overlaps with the gate insulating layer 30. In another exemplary embodiment of this invention, the pixel electrode 92 may overlap with the first passivation film 72 and/or the second passivation film 82 in an area of the storage electrode 28 when the first passivation film 72 and/or the second passivation film 82 are arranged on the storage electrode 28. The gate insulating layer 30, the first passivation film 72, and the second passivation film 82, which are interposed between the storage electrode 28 and the pixel electrode 92, may have a uniform thickness to increase a driving margin.

The auxiliary gate pad 96 connected to the gate pad 27 is arranged in the formation area of the gate pad 27, and the auxiliary data pad 97 connected to the data pad 67 is arranged in the formation area of the data pad 67. The auxiliary gate pad 96 and the auxiliary data pad 97 may be formed of the same material, which may be the same material used to form the pixel electrode 92. ,

Hereinafter, a method of fabricating a TFT array substrate will be described.

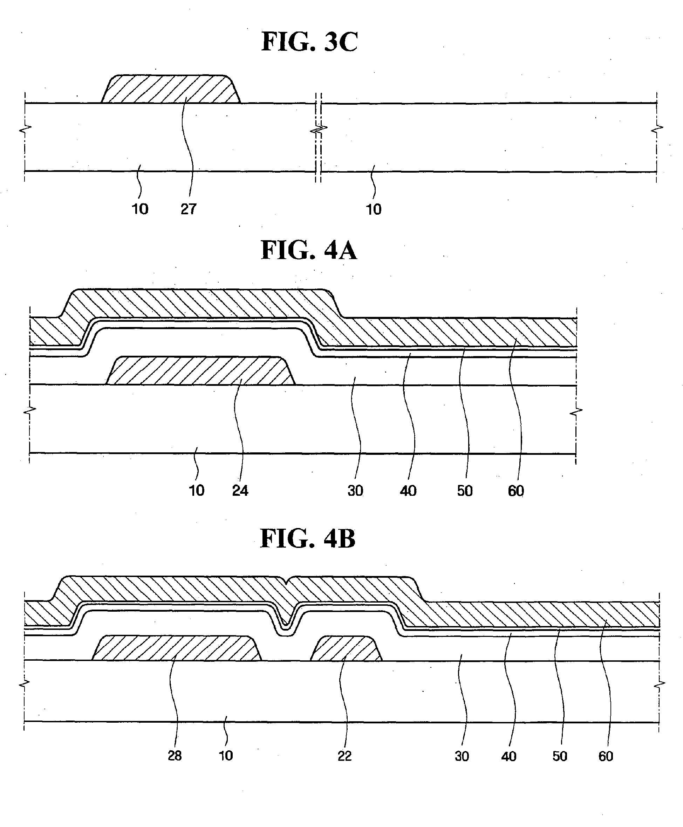

FIGS. 3A, 4A, 5A, 6A, 7A, 8A, 9A, 10A, and 11A are cross-sectional views showing processing steps of the method of fabricating the TFT array substrate cross-sectional view shown in FIG. 2A according to a second exemplary embodiment of the present invention. FIGS. 3B, 4B, 5B, 6B, 7B, 8B, 9B, 10B, and 11B are cross-sectional views showing processing steps of the method of fabricating the TFT array substrate cross-sectional view shown in FIG. 2B according to the second exemplary embodiment of the present invention. FIGS. 3C, 4C, 5C, 6C, 7C, 8C, 9C, 10C, and 11C are cross-sectional views showing processing steps of the method of fabricating the TFT array substrate cross-sectional view shown in FIG. 2C according to the second exemplary embodiment of the present invention.

Referring first to FIG. 3A, FIG. 3B, and FIG. 3C, the gate interconnection line and the storage electrode 28 are formed on the insulating substrate 10. More specifically, a gate conductive layer is deposited on the insulating substrate 10 using, for example, sputtering, and is then photo-etched, thereby forming the gate line 22, the gate pad 27, the gate electrode 24, and the storage electrode 28.

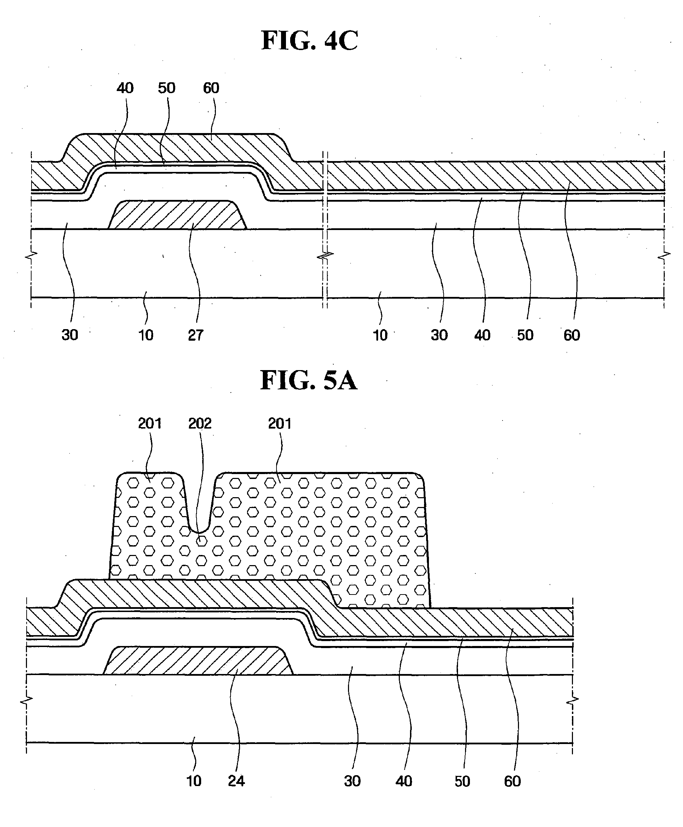

Referring to FIG. 4A, FIG. 4B, and FIG. 4C, a gate insulating layer 30, a first amorphous silicon layer 40, which may be made of hydrogenated amorphous silicon, and a second amorphous silicon layer 50, which may be made of silicide or n+ hydrogenated amorphous silicon doped with high concentration n-type impurities, are deposited on the insulating substrate 10. The gate insulating layer 30, the first amorphous silicon layer 40, and the second amorphous silicon layer 50 may be deposited using, for example, chemical vapor deposition (CVD).

Next, a data conductive layer 60 is deposited on the second amorphous silicon layer 50 using, for example, sputtering.

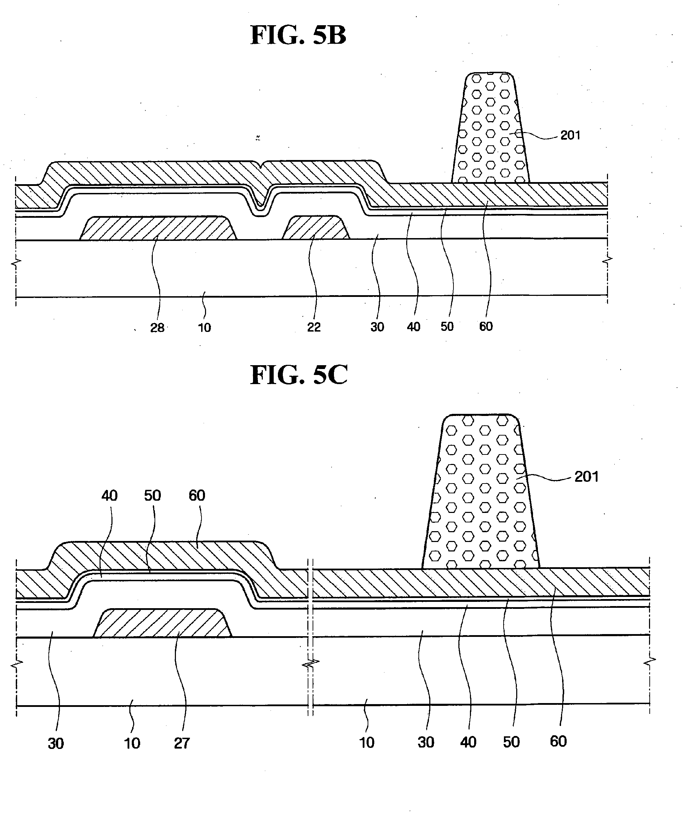

Referring to FIG. 5A, FIG. 5B, and FIG. 5C, a photoresist pattern 201 and 202 is formed on the data conductive layer 60. The photoresist pattern includes a first region 201 and a second region 202 having a smaller thickness than the first region 201. The first region 201 covers a formation area of a data line 62, a data pad 67, a source electrode 65, and a drain electrode 66 shown in FIG. 2A, FIG. 2B, and FIG. 2C. The second region 202 covers a space between the source electrode 65 and the drain electrode 66. Here, the size of the photoresist pattern 201 and 202 for each region is selected with the consideration that it may be reduced in sized during subsequent etching and ashing processes. The photoresist pattern having different thicknesses for different regions may be formed using a slit mask or a half-tone mask, which can also be applied to other photoresist patterns to be described below.

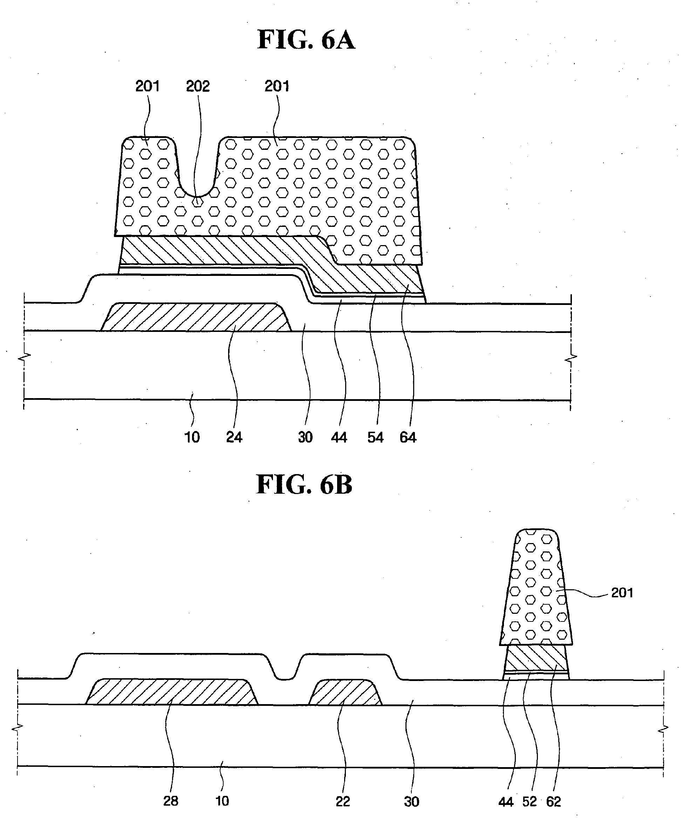

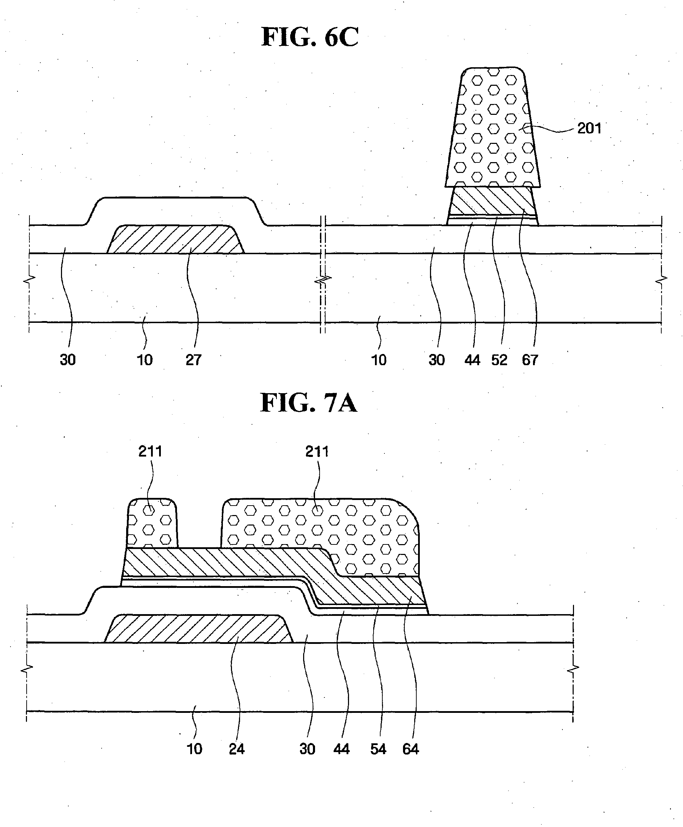

Referring to FIG. 6A, FIG. 6B, and FIG. 6C, the exposed data conductive layer 60 is etched using the photoresist pattern 201 and 202 shown in FIG. 5A, FIG. 5B, and FIG. 5C as an etching mask. The data conductive layer 60 may be etched using one of various methods depending on the required type and thickness of the data conductive layer 60, but may be etched using wet etching. As a result, patterns of the data line 62 and the data pad 67 are formed. However, patterns of the source electrode 65 and the drain electrode 66 are not yet formed and the data conductive layer 64 remains integrated in the channel region.

Once the data conductive layer 60 is etched, the second amorphous silicon layer 50 is exposed and the exposed second amorphous silicon layer 50 and the first amorphous silicon layer 40 thereunder are etched. The second amorphous silicon layer 50 and the first amorphous silicon layer 40 may be etched using, for example, dry etching. As a result, a semiconductor layer 44 is formed. In a region where the first amorphous silicon layer 40 is etched, the gate insulating layer 30 may be exposed. In this step, the photoresist pattern used as an etching mask is partially etched and thus is reduced in size. Patterns 52 and 54 of the etched second amorphous silicon layer and the completed semiconductor layer 44 are substantially the same as those of the data line 62, the data pad 67, and the data conductive layer 64 that is not separated in the channel region.

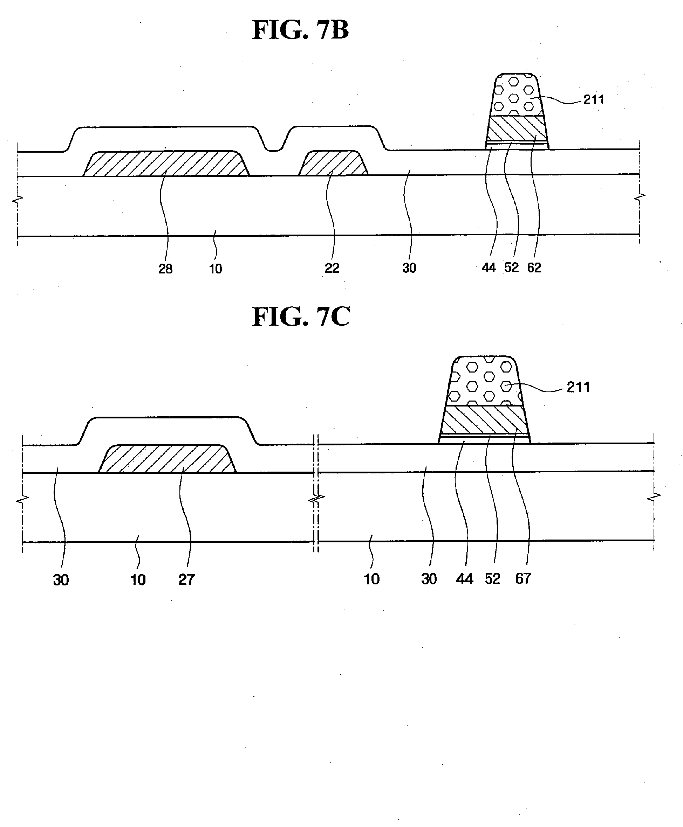

Referring to FIG. 7A, FIG. 7B, and FIG. 7C, the data conductive layer 64 is exposed by removing the second region 202 of the photoresist pattern. The second region 202 may be removed by an ashing process using O₂. At this time, the first region 211 is also reduced in size. In the above-described etching step, the second region 211 may be removed, and in this case, the ashing process may be skipped.

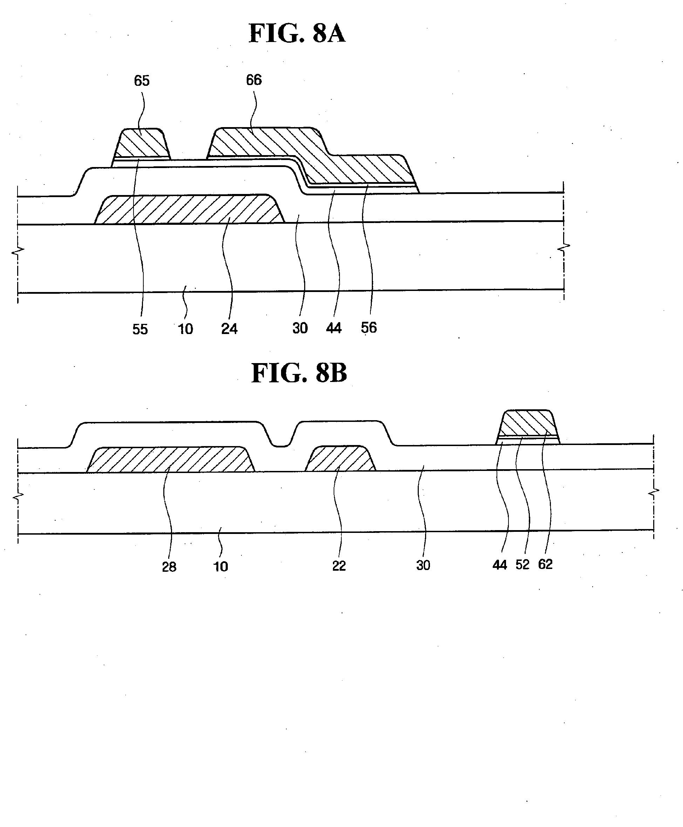

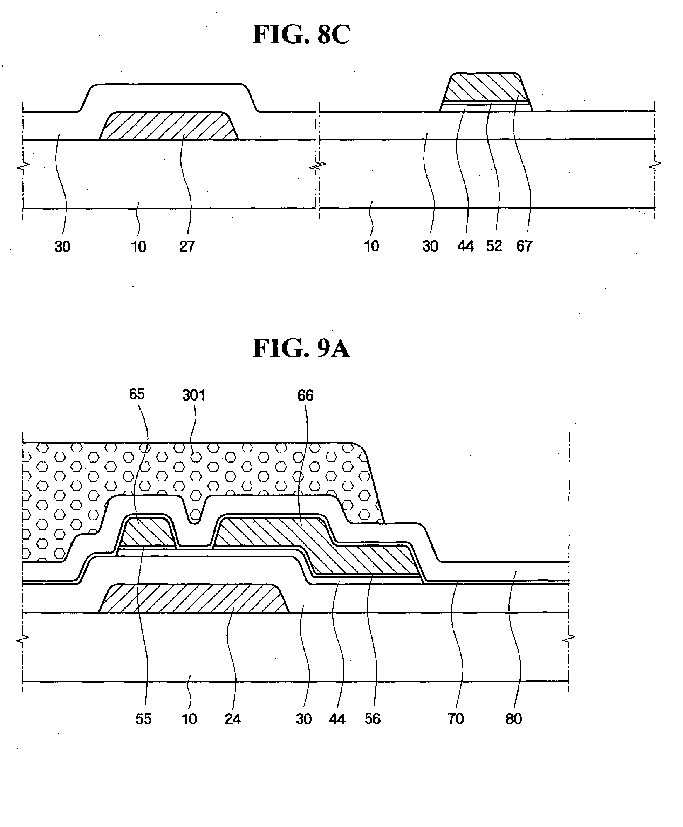

Referring to FIG. 8A, FIG. 8B, and FIG. 8C, a region of the exposed data conductive layer 64 corresponding to the channel region is etched using the first region 211 of the down-sized photoresist pattern as an etching mask. As a result, patterns of the source electrode 65 and the drain electrode 66 are formed and the second amorphous silicon layer 54 is exposed through the space between the source electrode 65 and the drain electrode 66. The exposed second amorphous silicon layer 54 is etched to be separated. As a result, ohmic contact layers 52, 55, and 56 are formed. The semiconductor layer 44 is exposed in an area where the second amorphous silicon layer 54 is etched.

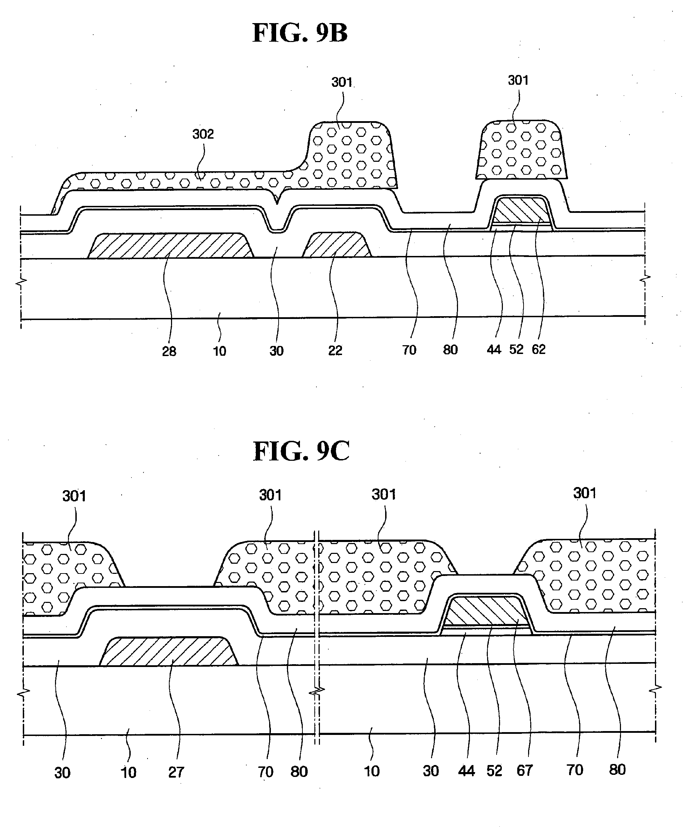

Referring to FIG. 9A, FIG. 9B, and FIG. 9C, a first insulating layer 70 and a second insulating layer 80 are sequentially deposited on the TFT array substrate obtained by performing the processing steps illustrated in FIG. 8A, FIG. 8B, and FIG. 8C using, for example, CVD.

Next, a photoresist pattern 301 and 302 is formed on the second insulating layer 80. The photoresist pattern includes a first region 301 and a second region 302 having a smaller thickness than the first region 301. The first region 301 covers a formation area of the gate interconnection line, a formation area of a data interconnection line, and a formation area of the semiconductor layer 44. However, the second insulating layer 80 remains exposed in a formation area of a drain electrode-pixel electrode contact portion 101, an area of the gate pad 27, and an area of the data pad 67. The second region 302 covers a formation area of the storage electrode 28.

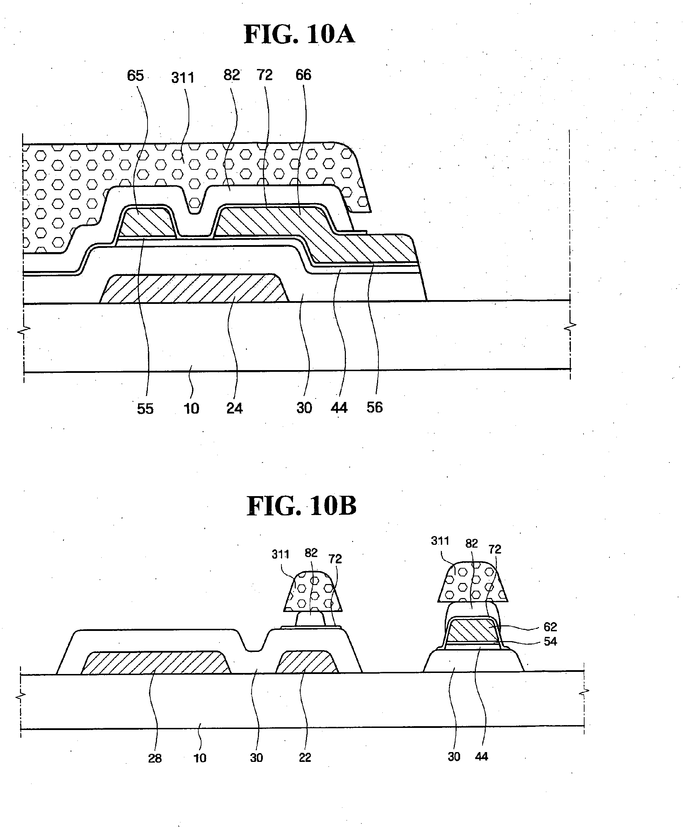

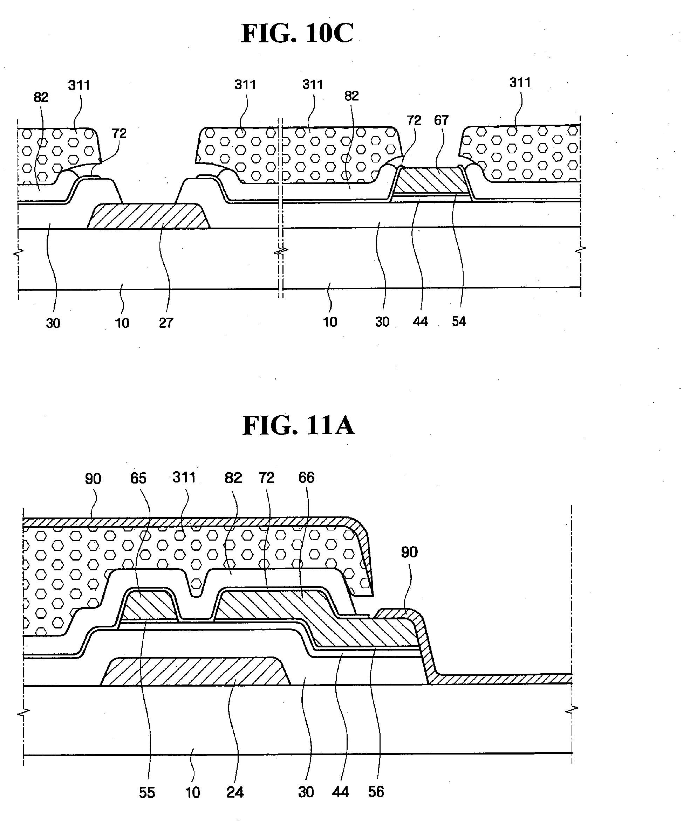

Referring to FIG. 10A, FIG. 10B, and FIG. 10C, the exposed second insulating layer 80 and the first insulating layer 70 thereunder are etched using the photoresist pattern 301 as an etching mask to form the second passivation film 82 and the first passivation film 72. The second insulating layer 80 and the first insulating layer 70 may be etched using, for example, dry etching. Here, the etching may be anisotropic etching or isotropic etching. In order to secure a lift-off margin due to an undercut, isotropic etching may be used.

An etching gas to etch the second insulating layer 80 and the first insulating layer 70 may be selected such that the second insulating layer 80 has a large etching selectivity with respect to the first insulating layer 70. More specifically, the selected etching gas may possess a higher etching rate with respect to the second insulating layer 80 than with respect to the first insulating layer 70. For example, an etching gas may be used that provides a 1:5 - 1:20 ratio of an etching rate with respect to the first insulating layer 70 to an etching rate with respect to the second insulating layer 80. CF₄, O₂, CF₄, SF₆, CHF₃, O₂, or combinations thereof may be used as an etching gas, and the etching rate can be controlled by adjusting the combination of constituents of the etching gas used or the composition ratio of the combination. A non-limiting example of the etching gas may include an etching gas of SF₆ and O₂ mixed in a ratio of 2:1.

By using such an etching gas, the time required to etch the first insulating layer 70 increases after etching the second insulating layer 80. Thus, while etching the first insulating layer 70, the second insulating layer 80 can be sufficiently over-etched under the inner side of the photoresist pattern 301, thereby securing an undercut having a sufficiently large width. During over-etching of the second insulating layer 80, structures such as the data pad 67 and the drain electrode 66 may be protected from etching by being covered with the first insulating layer 70. Thus, even when a material susceptible to dry etching, such as molybdenum, is used for the data interconnection line, it may be protected from etching by the first insulating layer 70. Since the data pad 67 and the drain electrode 66 are not excessively etched during the etching process, a sufficiently large contact area between conductive materials can be achieved in the drain electrode-pixel electrode contact portion 101 and in the data contact portion 77. In addition, the semiconductor layer 44 is protected by the first insulating layer 70 during over-etching of the second passivation film 82, thereby preventing undercut of the semiconductor layer 44.

Since the first insulating layer 70 has a low etching rate, it is patterned along the mask of the photoresist pattern 301 and 302, generating only a small amount of undercut. Thus, after etching the first insulating layer 70 to form the first passivation film 72, a sidewall of the first passivation film 72 extends beyond a sidewall of the second passivation film 82.

Upon completion of etching the first passivation film 72, the gate insulating layer 30 under the first passivation film 72 is etched. In this step, the second passivation film 82 is over-etched to the inside of the gate insulating layer 30 and the width of the undercut increases. For example, the width of the undercut formed by the second passivation film 82 may be about 4 µm to about 30 µm.

When the gate insulating layer 30 is formed of a material that is the same as or has the same etching rate as the second passivation film 82, the etching rate of the gate insulating layer 30 may be larger than the etching rate of the first passivation film 72. Thus, an undercut formed in the gate insulating layer 30 may be formed under the first passivation film 72 due to this etching rate difference. In this case, since the gate insulating layer 30 is exposed to an etching gas for a smaller amount of time than the second passivation film 82, the extent to which the gate insulating layer 30 is etched may be small. Thus, the degree of protrusion of the first passivation film 72 with respect to the second passivation film 82 is larger than that of the first passivation film 72 with respect to the gate insulating layer 30. In other words, the outer sidewall of the second passivation film 82 is positioned inside the outer sidewall of the gate insulating layer 30. The relationship between positions of the gate insulating layer 30 and the first passivation film 72 may vary according to processing conditions. By controlling the composition of an etching gas, the concentration of the etching gas, the thickness of each structure, and the etching processing time, the degree of protrusion of the first passivation film 72 with respect to the gate insulating layer 30 can be minimized or the sidewalls of the first passivation film 72 and the gate insulating layer 30 can be aligned with each other. Moreover, by controlling the etching conditions and changing the etching of the gate insulating layer 30 into anisotropic etching, the outer sidewall of the first passivation film 72 may be positioned inside the outer sidewall of the gate insulating layer 30.

As a result of the etching, the drain electrode 66 is exposed and the insulating substrate 10 in a pixel region is also exposed. The gate pad 27 and the data pad 67 are also exposed, thereby forming a gate contact portion 76 and the data contact portion 77, respectively.

The photoresist pattern 301 and 302 may be reduced in size during etching of the second insulating layer 80, the first insulating layer 70, and the gate insulating layer 30, which are not covered by the photoresist pattern 301 and 302. By reducing the thickness of the second region 302 of the photoresist pattern or using an etching gas providing a high etching rate with respect to the photoresist pattern 301 and 302, the second region 302 of the photoresist pattern can be removed and only a region 311 having a reduced size can remain after the etching step, as shown in Fig. 10A, FIG. 10B, and FIG. 10C. Here, the remaining insulating layers 30, 70, and 80 under the second region 302 can be adjusted according to the thickness of the second region 302 of the photoresist pattern and/or the etching rate with respect to the photoresist pattern 301 and 302.

For example, if it is assumed that only the second region 302 of the photoresist pattern is selectively removed and the insulating layers 30, 70, and 80 all remain when the thickness of the second region 302 of the photoresist pattern is a first thickness and the etching rate with respect to the photoresist pattern 301 and 302 is a first etching rate, the thickness of the second region 302 may be a second thickness larger than the first thickness or an etching gas providing a second etching rate with respect to the photoresist pattern 301 and 302 that is higher than the first etching rate may be used. Thus, the second insulating layer 80 may be removed and layers under the first insulating layer 70 may remain. The thickness of the second region 302 may be a third thickness that is larger than the second thickness or an etching gas providing a third etching rate with respect to the photoresist pattern 301 and 302 that is higher than the second etching rate may be used. Thus, the second insulating layer 80 and the first insulating layer 70 may be removed and only the gate insulating layer 30 may remain.

Referring to FIG. 10B, to increase the storage capacity of the storage electrode 28, only the gate insulating layer 30 among insulating layers under the second region 302 may remain. Since the duration of the etching process may increase, during which time the gate insulating layer 30 is protected by the first insulating layer 70, non-uniform etching of the gate insulating layer 30 can be prevented. Thus, uniform storage capacity may be achieved and a driving margin may be increased. Similarly, when the gate insulating layer 30 and the first insulating layer 70 remain on the storage electrode 28, uniform storage capacity can be achieved by preventing non-uniform etching.

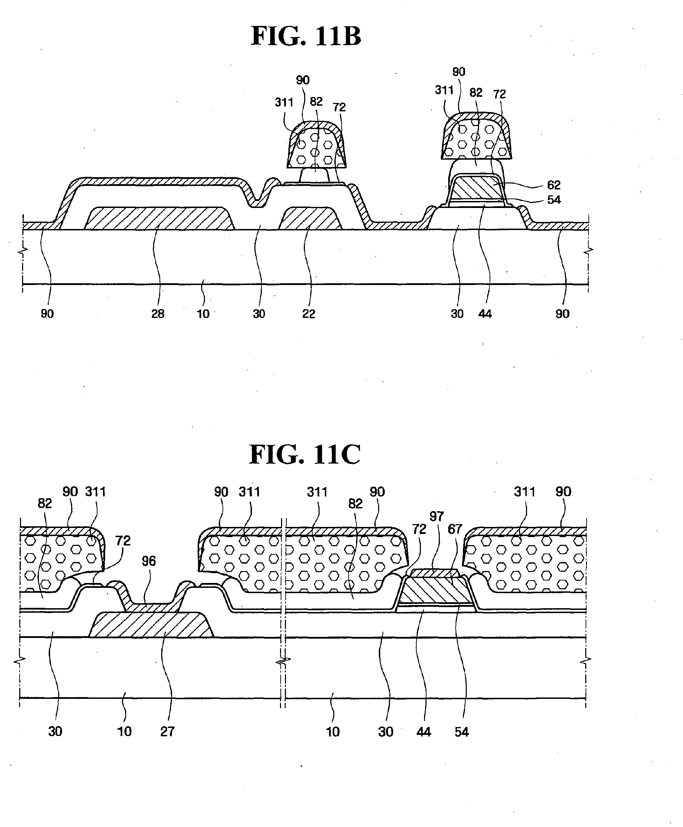

Referring to FIG. 11A, FIG. 11B, and FIG. 11C, a pixel electrode conductive material 90 is deposited on the entire surface of the insulating substrate 10 using, for example, sputtering. A portion of the pixel electrode conductive material 90 is deposited on the photoresist, pattern 311 and the remaining pixel electrode conductive material 90 is deposited on the exposed structure.

Referring back to FIG. 2A, FIG. 2B, and FIG. 2C, the photoresist pattern 311 and the pixel electrode conductive material 90 thereon may be removed using a lift-off process. More specifically, if a photoresist stripper including an amine group and a glycol group contacts the photoresist pattern 311 by spraying or dipping, it may exfoliate the photoresist pattern 311 from the second passivation film 82 by dissolving the photoresist pattern 311 and may remove the pixel electrode conductive material 90 on the photoresist pattern 311. Here, a removal rate of the photoresist pattern 311 and the pixel electrode conductive material 90 thereon is dependant on the contact time and contact area of the photoresist stripper on the photoresist pattern 311. In this step, since the width of the undercut formed by the first passivation film 72 under the first region 311 of the photoresist pattern is large, a contact area between the first region 311 of the photoresist pattern and the photoresist stripper increases. Therefore, it can be easily understood that the removal rate of the photoresist stripper with respect to the photoresist pattern 311 and the pixel electrode conductive material 90 thereon is improved. As a result of the removal of the photoresist pattern 311 and the pixel electrode conductive material 90, patterns of a pixel electrode 92, an auxiliary gate pad 96, and an auxiliary data pad 97 are formed.

Hereinafter, a method of fabricating a TFT array substrate according to a third exemplary embodiment of the present invention will be described. In the following description, the same structure and method as in the first embodiment of the present invention described with reference to FIGS. 3A through 11C and FIGS. 2A through 2C will be described in brief and the description will focus on a difference between the second exemplary embodiment of the present invention and the third exemplary embodiment of the present invention.

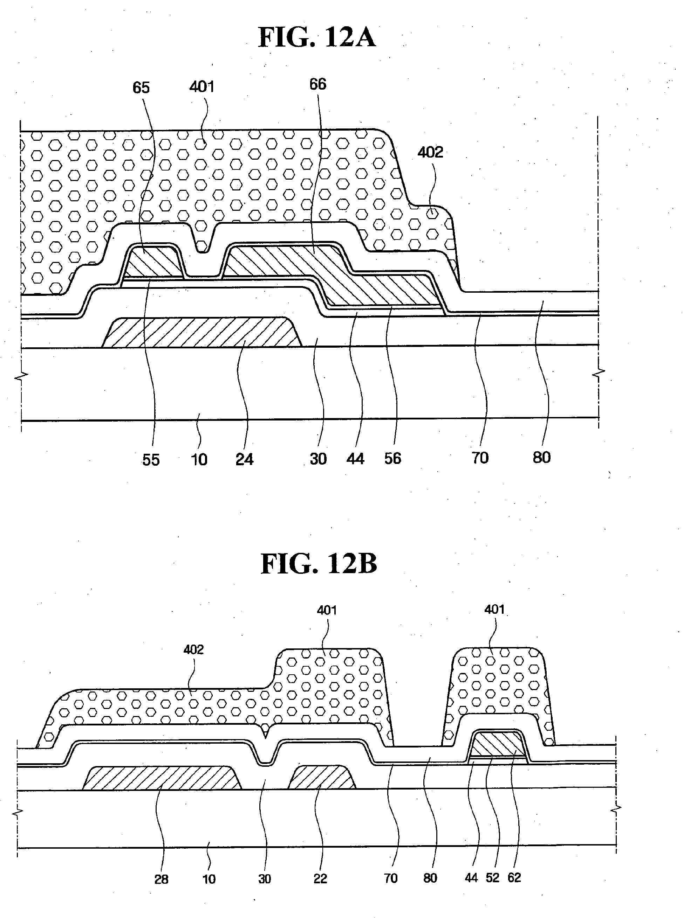

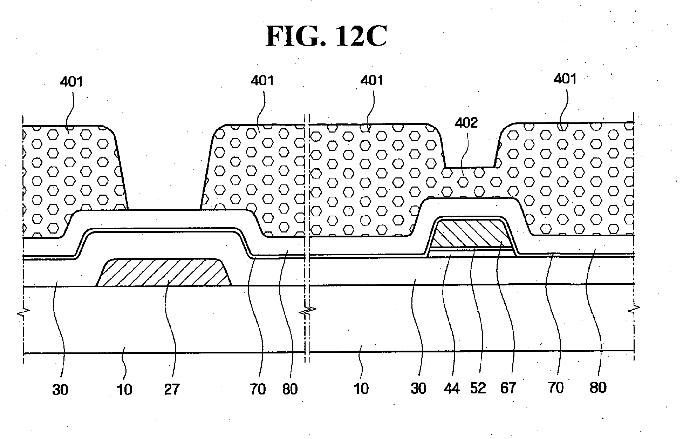

FIGS. 12A, 13A, 14A, and 15A are cross-sectional views showing processing steps of the method of fabricating the TFT array substrate cross-sectional view shown in FIG. 2A according to a third exemplary embodiment of the present invention. FIGS. 12B, 13B, 14B, and 15B are cross-sectional views showing processing steps of the method of fabricating the TFT array substrate cross-sectional view shown in FIG. 2B according to the third exemplary embodiment of the present invention. FIGS. 12C, 13C, 14C, and 15C are cross-sectional views showing processing steps of the method of fabricating the TFT array substrate cross-sectional view shown in FIG. 2C according to the third exemplary embodiment of the present invention.

The method according to the third exemplary embodiment of the present invention includes the same steps of forming patterns of the source electrode 65 and the drain electrode 66, and the ohmic contact layers 52, 55, and 56, and exposing the semiconductor layer 44 as in the method according to the second exemplary embodiment of the present invention.

Referring to FIG. 12A, FIG. 12B, and FIG. 12C, the first insulating layer 70 and the second insulating layer 80 are sequentially deposited on the structure resulting from performing these steps.

A photoresist pattern 401 and 402 is formed on the second insulating layer 80. The photoresist pattern includes a first region 401, and a second region 402 having a smaller thickness than the second region 402. The first region 401 covers a gate interconnection line, a formation area of a data interconnection line, and a formation area of the semiconductor layer 44. The second insulating layer 80 in a formation area of the gate pad 27 is exposed as in the second exemplary embodiment of the present invention. However, a formation area of a drain electrode-pixel electrode contact portion 101 and an area of the data pad 67 are covered with the second region 402 unlike in the second exemplary embodiment of the present invention. Since it is not necessary to remove the second region 402 during etching of the second insulating layer 80, the first insulating layer 70, and the gate insulating layer 30, the thickness of the second region 402 according to the third exemplary embodiment of the present invention may be larger than that of the second region 202 according to the second exemplary embodiment of the present invention.

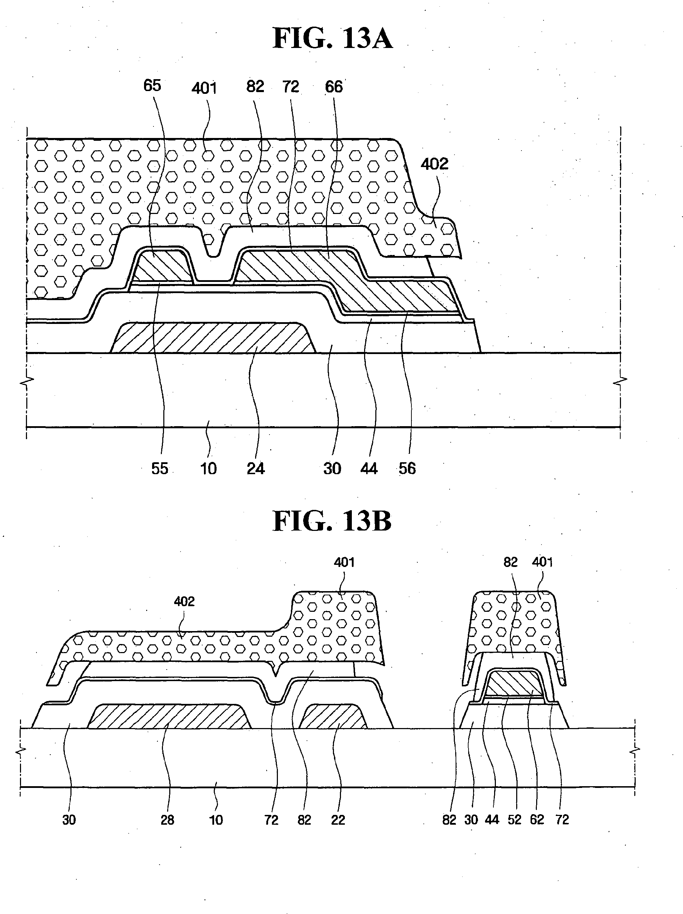

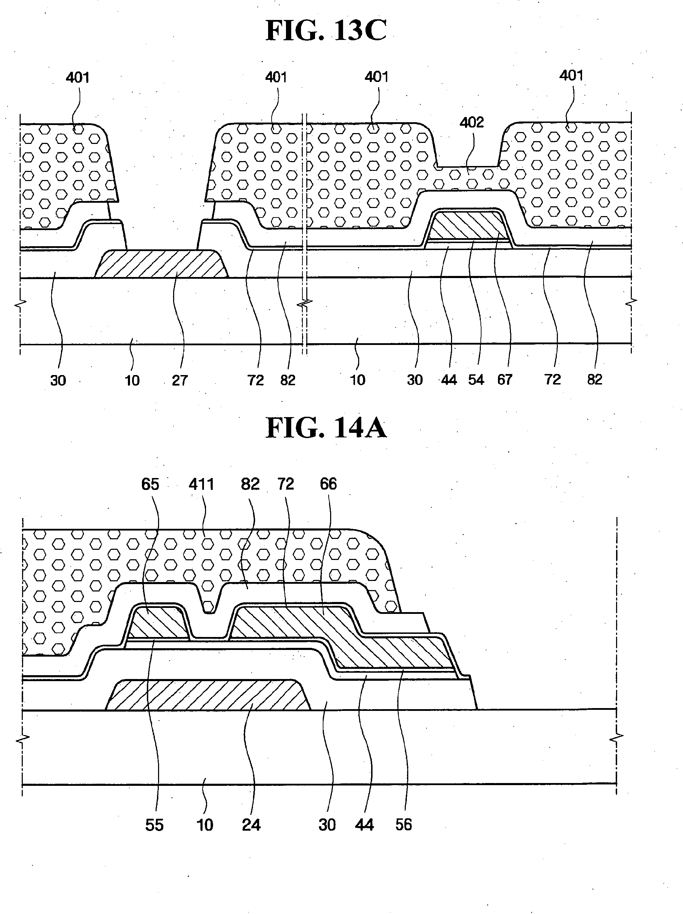

Referring to FIG. 13A, FIG. 13B, and FIG. 13C, the exposed second insulating layer 80, the first insulating layer 70 thereunder, and the gate insulating layer 30 are sequentially primarily etched using the photoresist pattern as an etching mask. The etching may be substantially similar as that of the second insulating layer 80, the first insulating layer 70, and the gate insulating layer 30 according to the second exemplary embodiment of the present invention. Thus, after etching is complete, the first passivation film 72 and the gate insulating layer 30 may extend beyond the second passivation film 82, and the outer sidewalls of the first passivation film 72 may be positioned inside the outer sidewalls of the gate insulating layer 30, may be aligned with the outer sidewalls of the gate insulating layer 30, or may be positioned on the outer sidewalls of the gate insulating layer 30. However, since a formation area of the drain electrode-pixel electrode contact portion 101 and the data pad 67 are protected by the second region 402 of the photoresist pattern, damage to the drain electrode 66 and the data pad 67 can be further prevented. Moreover, the semiconductor layer 44 may be protected by the second passivation film 82, thereby preventing undercut of the semiconductor layer 44. In this step, the photoresist pattern 401 and 402 used as an etching mask may be partially etched and thus reduced in size.

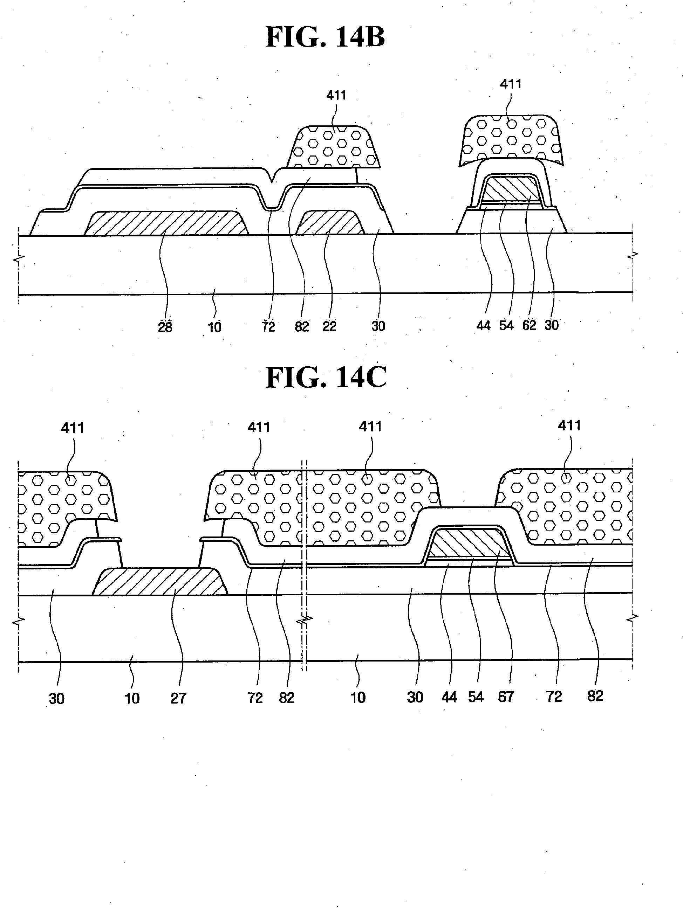

Referring to FIG. 14A, FIG. 14B, and FIG. 14C, the second region 402 of the photoresist pattern is removed to expose the drain electrode-pixel electrode contact portion 101, the data pad 67, and the second passivation film 82 on the storage electrode 28. The second region 402 may be removed by an ashing process using O₂. The photoresist pattern 411 may be reduced in size. The second region 402 of the photoresist pattern may have been removed during the primary etching, in which case the ashing process may be skipped.

Referring to FIG. 14A, FIG. 14B, and FIG. 14C, the second passivation film 82 and the first passivation film 72 in the drain electrode-pixel electrode contact portion 101, a formation area of the data pad 67, and a formation area of the storage electrode 28 may be secondarily etched using the first region 411 of the down-sized photoresist pattern. During the secondary etching, the drain electrode 66 on the drain electrode-pixel electrode contact portion 101, the data pad 67, and the gate insulating layer 30 on the storage electrode 28 are exposed. Since the etching rate of the first insulating layer 70 is lower than that of the second insulating layer 80, the width of the undercut of the second passivation film 82 further increases during the secondary etching.

During the secondary etching, unlike the primary etching that is full-surface etching, the gate insulating layer 30 is not etched and only the drain electrode-pixel electrode contact portion 101, and the second insulating layer 80 and the first insulating layer 70 in a formation area of the storage electrode 28 are etched, which may be referred to as partial-surface etching. For example, the primary etching may be performed for about 30 to about 200 seconds, but the secondary etching may be performed for about 10 to about 20 seconds. Thus, since the drain electrode 66 and the data pad 67 exposed by secondary etching are prevented from being damaged by an etching gas, a sufficiently large contact area between conductive materials in the drain electrode-pixel electrode contact portion 101 and the data contact portion 77 can be provided. Moreover, the gate insulating layer 30 on the storage electrode 28 may be prevented from being damaged by an etching gas, thereby providing uniformity of the thickness of the gate insulating layer 30 and thus increasing a driving margin. Furthermore, the time during which the semiconductor layer 44 is exposed to the etching gas may be small, thereby preventing undercut.

The deposition of a pixel electrode conductive material on the insulating substrate 10 after the step of second etching, and the removal of the photoresist pattern are substantially similar as in the first exemplary embodiment of the present invention. Thus, these steps will not be described.

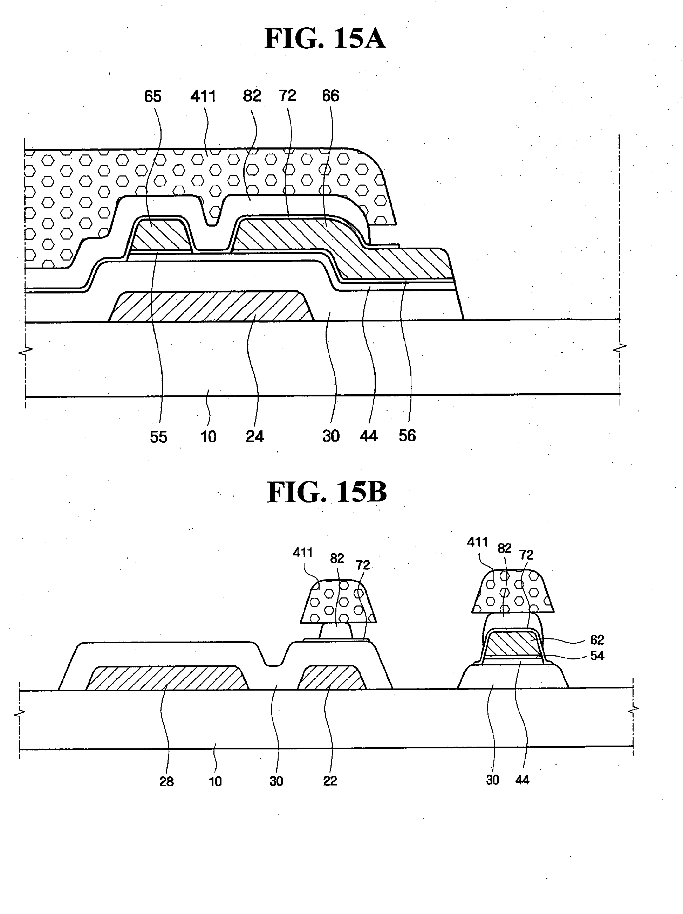

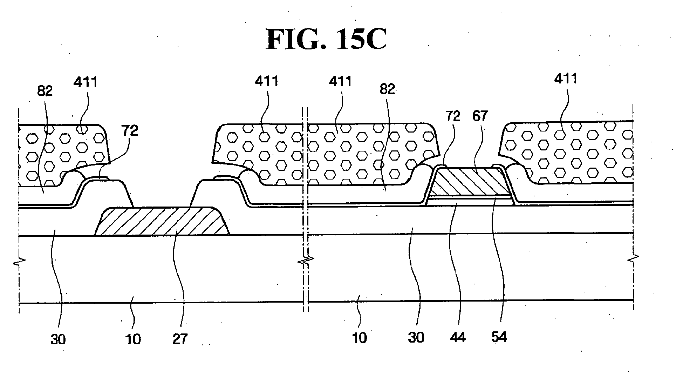

In the third exemplary embodiment of the present invention as shown in FIGS. 12A through 15C, a formation area of the gate pad 27 is exposed without being covered with the photoresist pattern 401 and 402. However, in a modified embodiment of the third exemplary embodiment of the present invention, the photoresist pattern may cover the area where the gate pad 27 is formed. In this case, a portion of the photoresist pattern covering the area where the gate pad 27 is formed may be a third region (not shown) having a smaller thickness than the second region 402. The third region thickness may be such that it is entirely removed and the second insulating layer 80, the first insulating layer 70, and/or the gate insulating layer 30 under the third region are partially removed during the primary etching. Further, the gate insulating layer 30 covering the gate pad 27 may be entirely removed during the secondary etching.

In another modified embodiment of the third exemplary embodiment of the present invention, the second region 402 of the photoresist pattern covering the drain electrode-pixel electrode contact portion 101 and/or the area where the data pad 67 is formed may be partially or entirely omitted.

The methods of fabricating the TFT array substrate according to the second exemplary embodiment and the third exemplary embodiment of the present invention are different in that etching of the first passivation film and etching of the second passivation film are performed simultaneously or separately, but the methods may be partially combined with each other.

For example, the drain electrode-pixel electrode contact portion 101 and/or the area where the data pad 67 is formed according to the current embodiment of the present invention may be covered with the second region 402 of the photoresist pattern. In this case, the second region 402 of the photoresist pattern and the second passivation film and the first passivation film under the second region may be entirely removed during etching of the second passivation film, the first passivation film, and the gate insulating layer in an exposed region. However, such a combination is only an example.

Hereinafter, a TFT array substrate according to a fourth exemplary embodiment of the present invention will be described. The same structures as in the first embodiment of FIG. 1, FIG. 2A, FIG. 2B, and FIG. 2C will be described in brief.

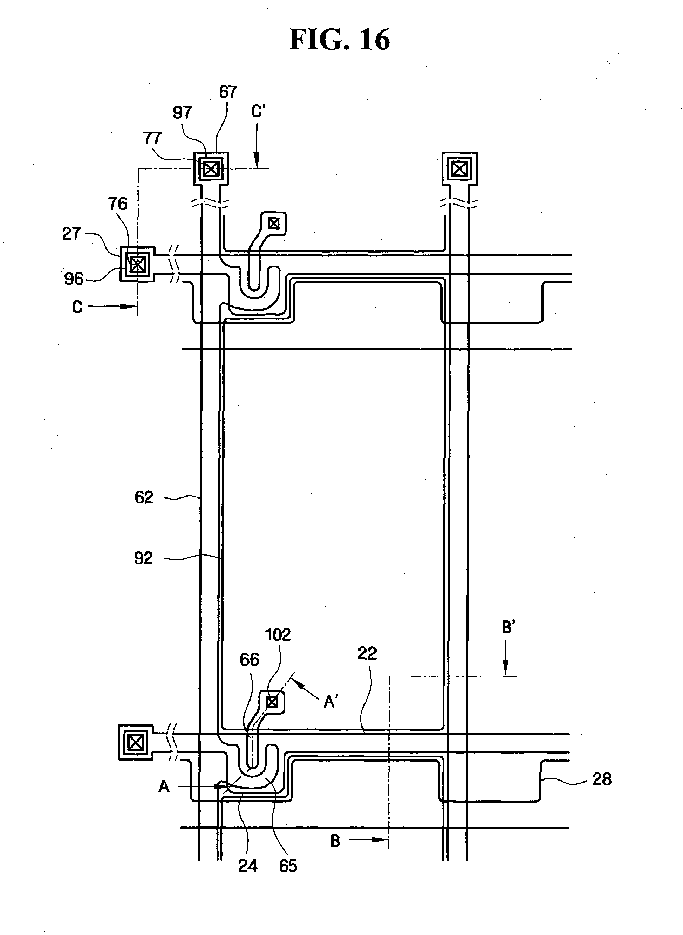

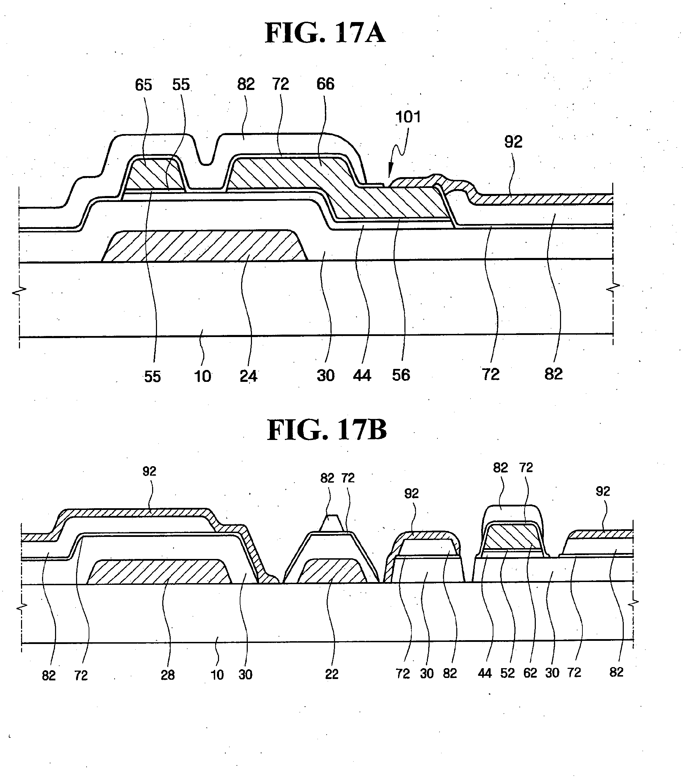

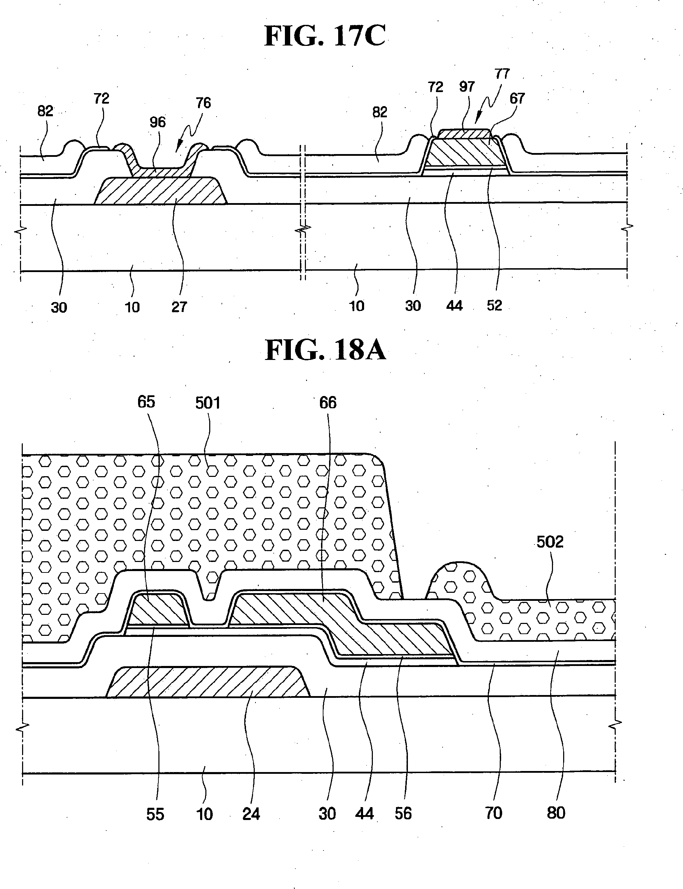

FIG. 16 is a layout of a TFT array substrate according to a fourth exemplary embodiment of the present invention and FIG. 17A, FIG. 17B, and FIG. 17C are cross-sectional views taken along lines A-A', B-B', and C-C', respectively, of FIG. 16.

Referring to FIG. 16, FIG. 17A, FIG. 17B, and FIG. 17C, the TFT array substrate according to the fourth exemplary embodiment of the present invention is different from that according to the first exemplary embodiment of the present invention in that a gate insulating layer 30 is arranged on an entire surface of the insulating substrate 10 except for a peripheral area of a gate line 22, a peripheral area of the data line 62, and the gate contact portion 76. According to a manufacturing process, the peripheral area of the gate line 22 and the peripheral area of the data line 62 may not be separated. In a pixel region, a pixel electrode 92 overlaps with the gate insulating layer 30, the first passivation film 72, and the second passivation film 82 and is positioned on the second passivation film 82. The first passivation film 72 and the second passivation film 82 as well as the gate insulating layer 30 are interposed between the pixel electrode 92 and the storage electrode 28.

The first passivation film 72 and the second passivation film 82 cover most of a formation area of the gate insulating layer 30 except for a formation area of the data contact portion 77 where the data pad 67 contacts the auxiliary data pad 97,and the drain electrode-pixel electrode contact portion 101. However, in a formation area of the gate line 22 and the data line 62, the gate line 22 and the data line 62 are separated to separate the pixel electrode 92 for each pixel. The drain electrode-pixel electrode contact portion 101 is surrounded by the first passivation film 72 and the second passivation film 82. In the current exemplary embodiment of the present invention, the first passivation film 72 is entirely overlapped by the second passivation film 82.

Since the pixel electrode 92 is arranged on the gate insulating layer 30, the first passivation film 72, and the second passivation film 82 in the TFT array substrate according to the current exemplary embodiment of the present invention, a step between a formation area of the pixel electrode 92 and a formation area of the TFT is reduced. Thus, by applying the TFT array substrate to an LCD, the uniformity of a cell gap can be improved.

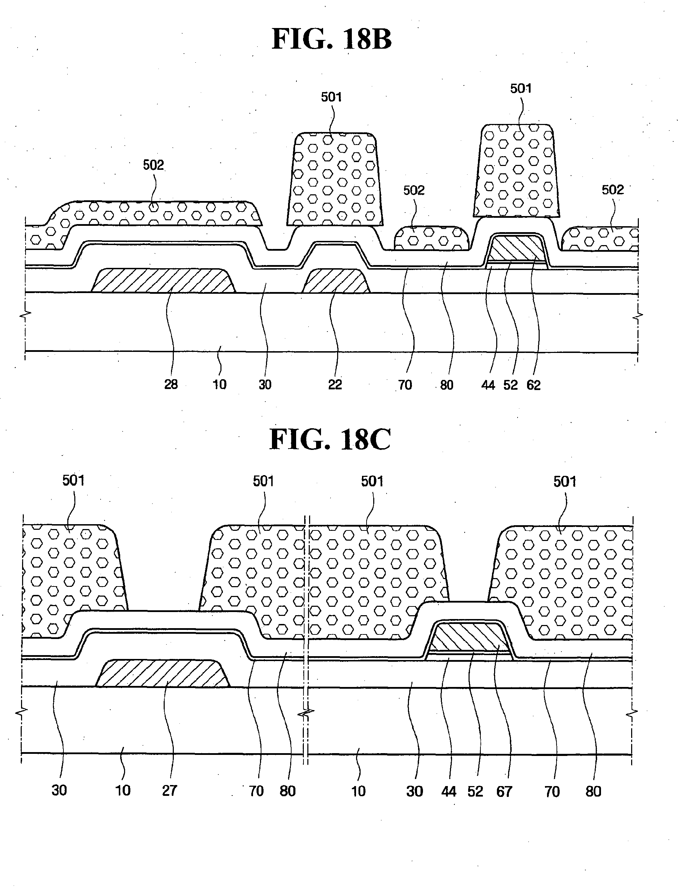

FIGS. 18A, 19A, 20A, and 21A are cross-sectional views showing processing steps of the method of fabricating the TFT array substrate cross-sectional view shown in FIG. 17A according to a fifth exemplary embodiment of the present invention. FIGS. 18B, 19B, 20B, and 21B are cross-sectional views showing processing steps of the method of fabricating the TFT array substrate cross-sectional view shown in FIG. 17B according to the fifth exemplary embodiment of the present invention. FIGS. 18C, 19C, 20C, and 21C are cross-sectional views showing processing steps of the method of fabricating the TFT array substrate cross-sectional view shown in FIG. 17C according to the fifth exemplary embodiment of the present invention.

The method according to the current exemplary embodiment of the present invention includes substantially the same steps of forming patterns of the source electrode 65 and the drain electrode 66, and ohmic contact layers 52, 55, and 56, and exposing the semiconductor layer 44 as in the second exemplary embodiment of the present invention.

Referring to FIG. 18A, FIG. 18B, and FIG. 18C, the first insulating layer 70 and the second insulating layer 80 are sequentially deposited on the structure resulting from performing the above steps.

The photoresist pattern 501 and 502 is formed on the second insulating layer 80. The photoresist pattern includes a first region 501, and a second region 502 having a smaller thickness than the first region 501. Here, the first region 501 covers a formation area of the gate interconnection line, a formation area of the data interconnection line, and a formation area of the semiconductor layer 44. However, a formation area of the gate pad 27, a formation area of the data pad 67, and the second insulating layer 80 of the drain electrode-pixel electrode contact portion 101 are exposed. The second region 502 covers most of the pixel region as well as a formation area of the storage electrode 28, but a peripheral area of the gate line 22 and a peripheral area of the data line 62 are exposed.

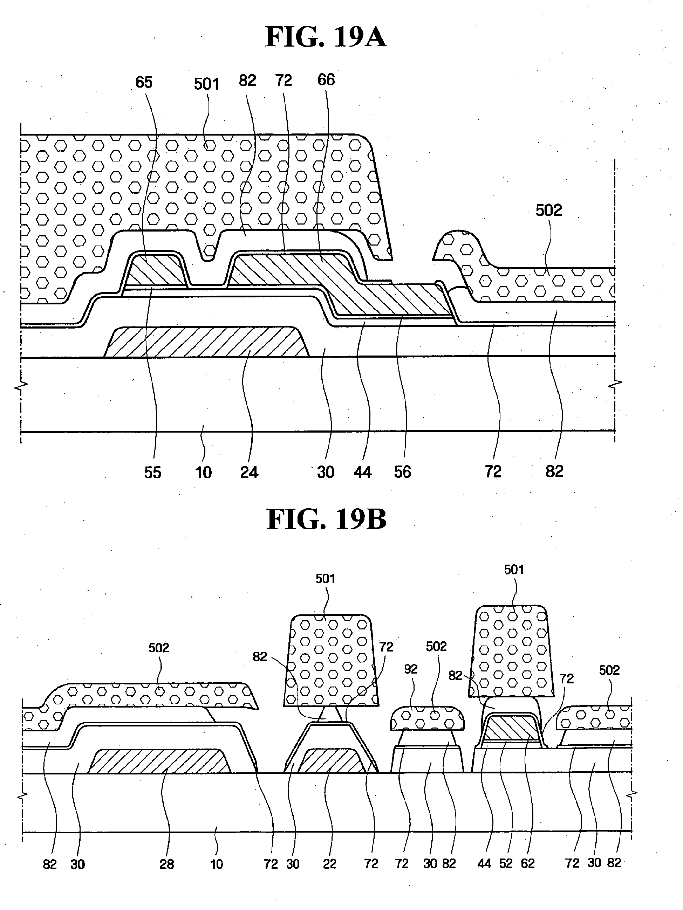

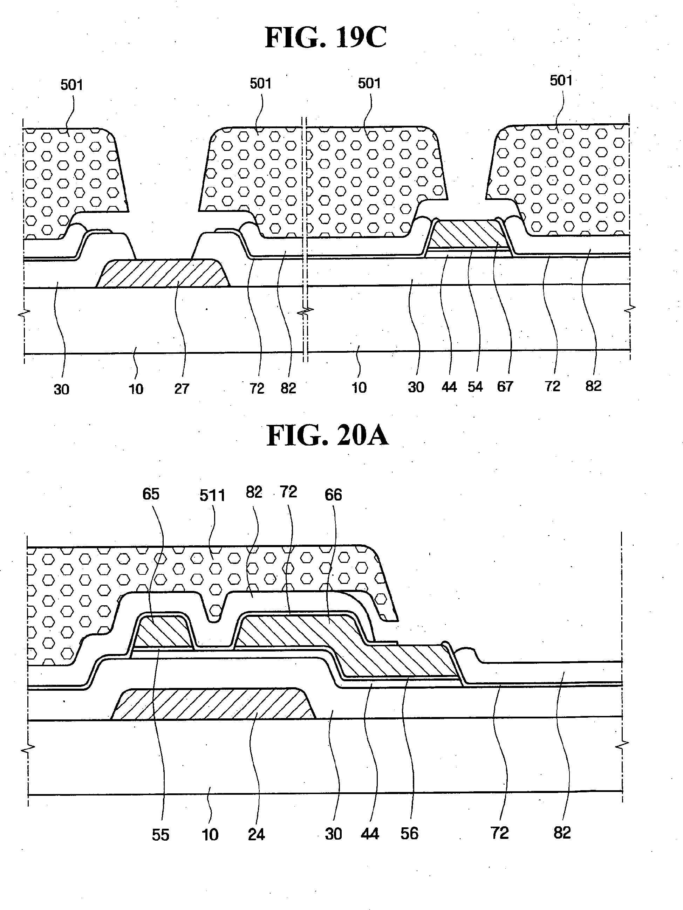

Referring to FIG. 19A, FIG. 19B, and FIG. 19C, the exposed second insulating layer 80, the first insulating layer 70, and the gate insulating layer 30 are etched using the photoresist pattern 501 and 502 as an etching mask to form the second passivation film 82 and the first passivation film 72. As a result, the drain electrode 66 of the drain electrode-pixel electrode contact portion 101 is exposed and the insulating substrate 10 in the peripheral area of the gate line 22 and the peripheral area of the data line 62 is exposed. The gate pad 27 and the data pad 67 are exposed and thus the gate contact portion 76 and the data contact portion 77 are formed. Here, etching of the second insulating layer 80 and the first insulating layer 70 is performed using an etching gas having a higher etching rate with respect to the second insulating layer 80 than the first insulating layer 70 as in the second exemplary embodiment. Thus, the second passivation film 82 under the photoresist pattern 501 and 502 may be etched to include an undercut having a sufficiently large width.

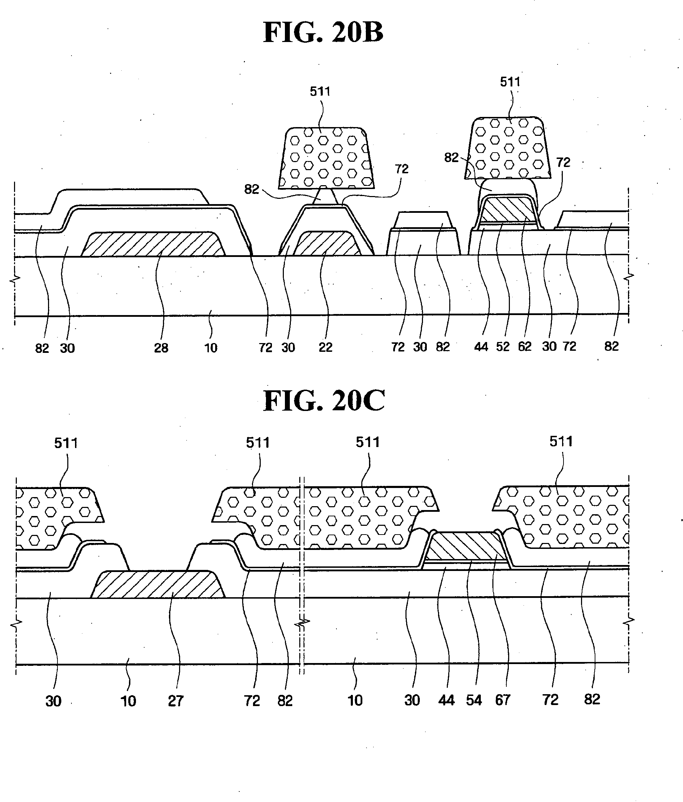

Referring to FIG. 20A, FIG. 20B, and FIG. 20C, the second region 502 of the photoresist pattern is removed. The second region 502 may be removed by an ashing process using O₂. Here, the photoresist pattern 511 may be reduced in size. Once the second region 502 of the photoresist pattern is removed, the second passivation film 82 of the pixel region is exposed. The second region 502 of the photoresist pattern may have been removed during etching of the second insulating layer 80 and the first insulating layer 70 thereunder, in which case the ashing process may be skipped.

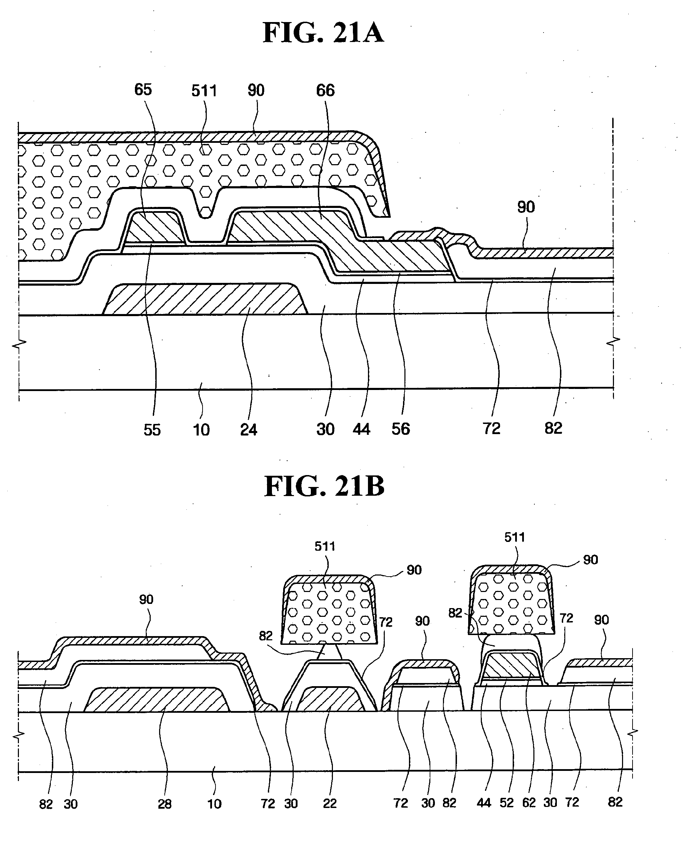

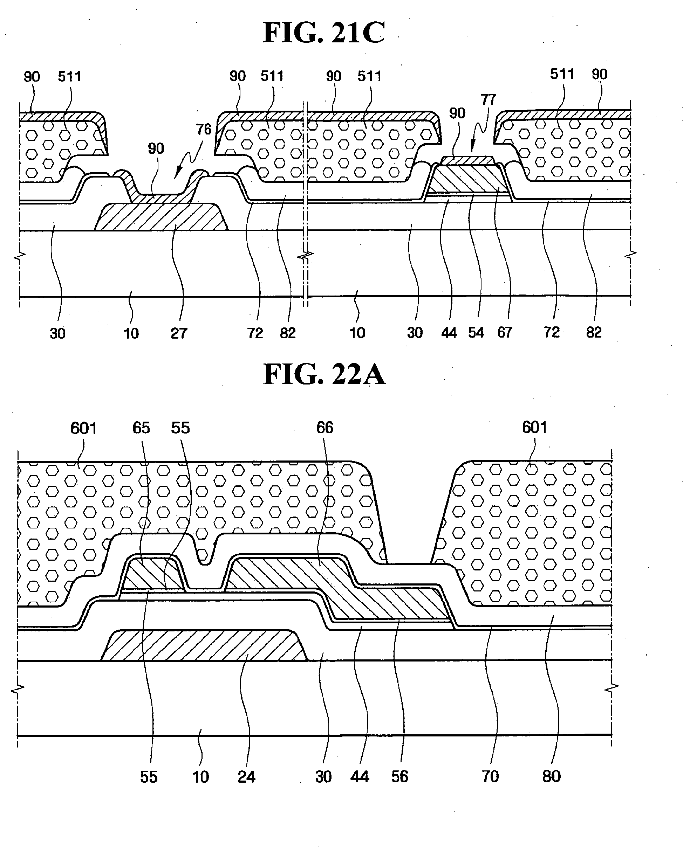

Referring to FIG. 21A, FIG. 21B, and FIG. 21C, the pixel electrode conductive material 90 is deposited on the insulating substrate 10.

The photoresist pattern 511 and the pixel electrode conductive material 90 above the photoresist pattern 511 are removed. This step may be performed in a substantially similar manner as the lift-off process described in the second exemplary embodiment of the present invention. As a result, as shown in FIG. 17A, FIG. 17B, and FIG. 17C, patterns of the pixel electrode 92, the auxiliary gate pad 96, and the auxiliary data pad 97 are formed.

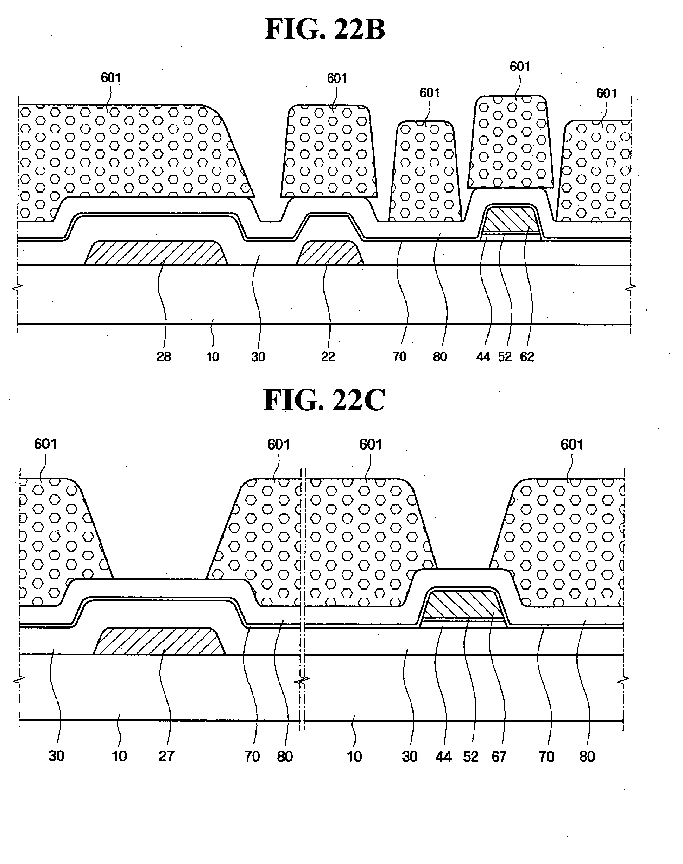

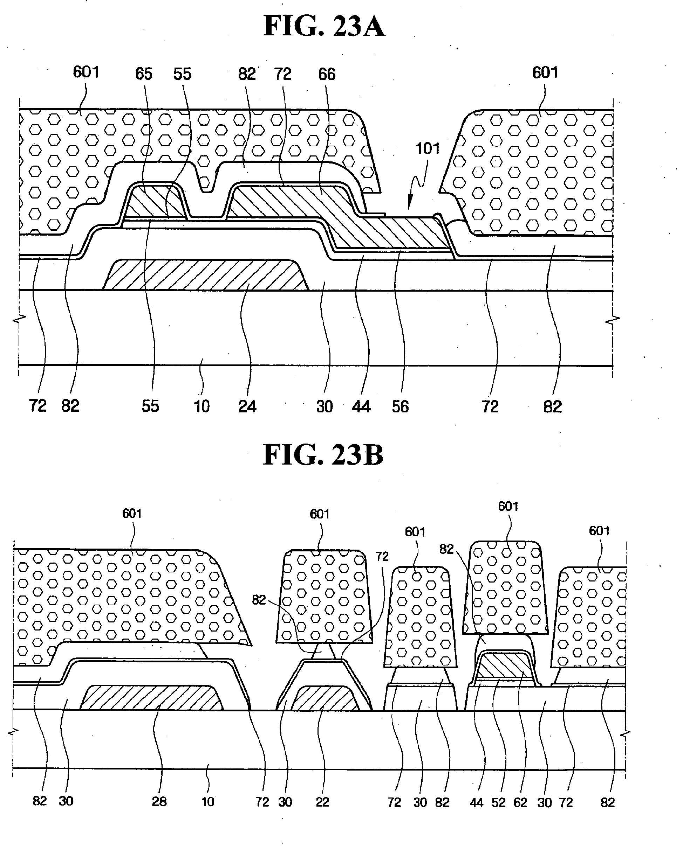

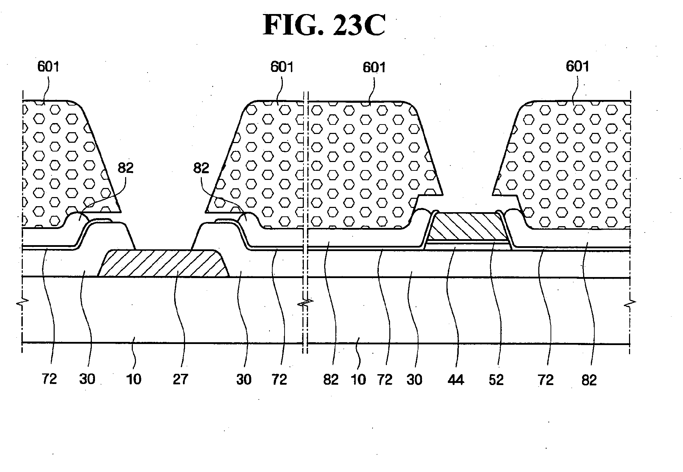

FIGS. 22A and 23A are cross-sectional views showing processing steps of the method of fabricating the TFT array substrate cross-sectional view shown in FIG. 17A according to a sixth exemplary embodiment of the present invention. FIGS. 22B and 23B are cross-sectional views showing processing steps of the method of fabricating the TFT array substrate cross-sectional view shown in FIG. 17B according to the sixth exemplary embodiment of the present invention. FIGS. 22C and 23C are cross-sectional views showing processing steps of the method of fabricating the TFT array substrate cross-sectional view shown in FIG. 17C according to the sixth exemplary embodiment of the present invention.

The method according to the sixth exemplary embodiment of the present invention includes substantially similar steps of forming patterns of the source electrode 65 and the drain electrode 66, and the ohmic contact layers 52, 55, and 56, and exposing the semiconductor layer 44 as those in the second exemplary embodiment of the present invention.

Referring to FIG. 22A, FIG. 22B, and FIG. 22C, the first insulating layer 70 and the second insulating layer 80 are sequentially deposited on the structure resulting from performing the steps.

The photoresist pattern 601 is formed on the second insulating layer 80. Here, the photoresist pattern 601 is substantially similar as the photoresist pattern shown in previous exemplary embodiments except that photoresist pattern 601 has a uniform thickness without being separated into a first region and a second region.

Referring to FIG. 23A, FIG. 23B, and FIG. 23C, the exposed second insulating layer 80, the first insulating layer 70 thereunder, and the gate insulating layer 30 thereunder are etched using the photoresist pattern 601 as an etching mask to form the second passivation film 82 and the first passivation film 72. As a result, the drain electrode 66 of the drain electrode-pixel electrode contact portion 101 is exposed, and the insulating substrate 10 in the peripheral area of the gate line 22 and the peripheral area of the data line 62 is exposed. The gate pad 27 and the data pad 67 are also exposed and thus the gate contact portion 76 and the data contact portion 77 are formed. In this etching step, the drain electrode 66 and the data pad 67 under the first insulating layer 70 are protected from an etching gas until the first insulating layer 70 is etched and removed. Thus, the time during which the drain electrode 66 and the data pad 67 under the first insulating layer 70 are exposed to the etching gas is reduced, thereby preventing damage to the drain electrode 66 and the data pad 67 under the first insulating layer 70.

Although not shown in the figures, the photoresist pattern 601 is removed and the pixel electrode conductive material is deposited and is patterned using a photolithography process, thereby completing the pixel electrode 92, the auxiliary gate pad 96, and the auxiliary data pad 97 as shown in FIG. 17A, FIG. 17B, and FIG. 17C. Since the current exemplary embodiment of the present invention includes a photolithography process for a pixel electrode conductive material, it is not necessary to remove the second passivation film 82, the first passivation film 72, and the gate insulating layer 30 in the peripheral areas of the gate line 22 and the data line 62.

Although the patterns of the semiconductor layer and the ohmic contact layer are substantially the same as the pattern of the data interconnection line in the exemplary embodiments of the present invention described herein, the present invention is not limited thereto. In other words, in the exemplary embodiments of the present invention, the semiconductor layer and the ohmic contact layer may be formed only in the channel region. To form the patterns of the semiconductor layer and the ohmic contact layer, a photoresist pattern for forming the semiconductor layer and the ohmic contact layer and a photoresist pattern for forming the data interconnection line may be formed using separate masks unlike in the embodiments of the present invention. Since such a TFT array substrate and a method of fabricating the same are well known to those skilled in the art and a difference in subsequent processes can be easily understood by those skilled in the art, they will not be further described herein.

According to the present invention, an undercut having a sufficiently large width may be provided under the photoresist pattern, thereby providing a superior lift-off margin. Moreover, the uniform thickness of the insulating layer interposed between the storage electrode and the pixel electrode may increase a driving margin. Furthermore, the drain electrode and the data pad may be prevented from being damaged, thereby securing a sufficiently large contact area between conductive materials in the contact portion.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. A thin film transistor (TFT) array substrate, comprising:
a gate interconnection line comprising a gate line and a gate electrode arranged on an insulating substrate;
a gate insulating layer arranged on the gate interconnection line;
a semiconductor layer arranged on the gate insulating layer;
a data interconnection line comprising a data line, a source electrode, and a drain electrode arranged on the semiconductor layer;
a first passivation film arranged on the data interconnection line and exposing a portion of the drain electrode;
a second passivation film arranged on the first passivation film, wherein the outer sidewalls of the second passivation film are positioned inside the outer sidewalls of the first passivation film; and
a pixel electrode connected to the drain electrode.

2. The TFT array substrate of claim 1, wherein the first passivation film comprises silicon oxide or silicon oxy-nitride and the second passivation film comprises silicon nitride.

3. The TFT array substrate of claim 2, wherein the gate insulating layer is patterned to expose the insulating substrate in a pixel region, and a pixel electrode is arranged directly on the exposed insulating substrate in the pixel region.

4. The TFT array substrate of claim 3, wherein the outer sidewall of the second passivation film is positioned inside an outer sidewall of the gate insulating layer.

5. The TFT array substrate of claim 4, wherein the gate insulating layer comprises silicon nitride.

6. The TFT array substrate of claim 3, further comprising:
a storage electrode arranged on the insulating substrate, wherein the storage electrode overlaps with the pixel electrode and the gate insulating layer is disposed therebetween.

7. The TFT array substrate of claim 2, further comprising:
a gate pad arranged at an end of the gate line,
wherein the gate insulating layer further comprises a gate contact portion that exposes the gate pad, the gate insulating layer covers the entire surface of the insulating substrate except for a peripheral area of the gate line, a peripheral area of the data line, and the gate contact portion, and the pixel electrode is arranged directly on the second passivation film arranged on the gate insulating layer.

8. The TFT array substrate of claim 7, further comprising:
a storage electrode arranged on the insulating substrate, wherein the storage electrode overlaps with the pixel electrode, and the gate insulating layer, the first passivation film, and the second passivation film are disposed therebetween.

9. The TFT array substrate of claim 2, further comprising:
a data pad arranged at an end of the data line; and
an auxiliary data pad,
wherein the first passivation film and the second passivation film further comprise a data contact portion to expose the data pad, and the auxiliary data pad fully contacts the exposed data pad.

10. A method of fabricating a thin film transistor (TFT) array substrate, the method comprising:
forming a gate interconnection line on an insulating substrate, the gate interconnection line comprising a gate line and a gate electrode;
forming a gate insulating layer on the gate interconnection line;
forming a semiconductor layer and a data interconnection line on the semiconductor layer, the data interconnection line comprising a data line, a source electrode, and a drain electrode;
sequentially forming a first passivation film and a second passivation film on the data interconnection line;
etching the second passivation film and the first passivation film, and exposing a drain electrode of a drain electrode-pixel electrode contact portion; and
forming a pixel electrode connected to the drain electrode,
wherein etching the second passivation film and the first passivation film comprises forming the outer sidewalls of the second passivation film inside the outer sidewalls of the first passivation film.

11. The method of claim 10, wherein etching the second passivation film and the first passivation film comprises using an etching gas providing a higher etching rate with respect to the second passivation film than with respect to the first passivation film.

12. The method of claim 11, wherein etching the second passivation film and the first passivation film further comprises isotropic etching.

13. The method of claim 11, wherein the first passivation film comprises silicon oxide or silicon oxy-nitride and the second passivation film comprises silicon nitride.

14. The method of claim 13, wherein forming the gate interconnection line comprises forming the gate interconnection line and a storage electrode,
wherein etching the first passivation film and the second passivation film comprises etching the second passivation film, the first passivation film, and the gate insulating layer using a photoresist pattern as an etching mask, the photoresist pattern comprising a first region that covers a formation area of the gate line, a formation area of the data line, a formation area of the source electrode, and the drain electrode-pixel electrode contact portion, and a second region having a smaller thickness than the first region and covering a formation area of the storage electrode, and
wherein the photoresist pattern exposes a pixel region arranged outside the formation area of the storage electrode.

15. The method of claim 14, wherein the gate insulating layer comprises silicon nitride and etching the second passivation film and the first passivation film comprises positioning the outer sidewalls of the gate insulating layer outside the outer sidewalls of the second passivation film.

16. The method of claim 15, wherein forming the pixel electrode comprises:
depositing a pixel electrode conductive material on the photoresist pattern; and
performing a lift-off process.

17. The method of claim 13, wherein forming the gate interconnection line comprises forming the gate interconnection line and a storage electrode, and
wherein etching the second passivation film and the first passivation film comprises:
primary etching the second passivation film, the first passivation film, and the gate insulating layer using a photoresist pattern as an etching mask, the photoresist pattern comprising a first region that covers a formation area of the gate line, a formation area of the data line, a formation area of the source electrode, and the drain electrode-pixel electrode contact portion, and a second region having a smaller thickness than the first region and covering a formation area of the storage electrode, the photoresist pattern exposing a pixel region where the pixel electrode is formed outside the formation area of the storage electrode;
removing the second region; and
secondary etching the second passivation film and the first passivation film using the first region of the photoresist pattern as an etching mask.

18. The method of claim 17, wherein the gate insulating layer comprises silicon nitride and etching the second passivation film and the first passivation film comprises positioning the outer sidewalls of the gate insulating layer outside the outer sidewalls of the second passivation film.

19. The method of claim 18, wherein forming the pixel electrode comprises:
depositing a pixel electrode conductive material on the photoresist pattern; and
performing a lift-off process.

20. The method of claim 17, wherein the primary etching comprises full-surface etching and the secondary etching comprises partial-surface etching.

21. The method of claim 13, wherein forming the gate interconnection line comprises forming the gate interconnection line and a storage electrode, and
wherein etching the first passivation film and the second passivation film comprises etching the second passivation film, the first passivation film, and the gate insulating layer using a photoresist pattern as an etching mask, the photoresist pattern comprising a first region that covers a formation area of the gate line, a formation area of the data line, a formation area of the source electrode, and the drain electrode-pixel electrode contact portion, and a second region having a smaller thickness than the first region and covering a formation area of the pixel electrode, and
wherein the photoresist pattern exposes a peripheral area of the gate line, a peripheral area of the data line, and the drain electrode-pixel electrode contact portion.

22. The method of claim 21, wherein the gate insulating layer comprises silicon nitride and etching the second passivation film, the first passivation film, and the gate insulating layer comprises positioning the outer sidewalls of the gate insulating layer outside the outer sidewalls of the second passivation film.

23. The method of claim 22, wherein forming the pixel electrode comprises:
depositing a pixel electrode conductive material on the first region of the photoresist pattern; and
performing a lift-off process.

24. The method of claim 13, wherein forming the data interconnection line comprises forming a data pad at an end of the data line,
wherein the data pad is exposed during exposing of the drain electrode.
